# EUROPEAN PATENT APPLICATION

(11) **EP 4 783 557 A1**
(43) Date of publication of application: **29.07.2026**
(21) Application number: 24886043.9
(22) Date of filing: 30.09.2024
(51) Int. Cl.: H04M 1/02, H05K 5/03, G02B 1/10

(54) **COVER STRUCTURE AND ELECTRONIC DEVICE COMPRISING SAME**

(30) Priority: 03.11.2023 KR 20230150995; 15.12.2023 KR 20230182631
(71) Applicant: Samsung Electronics Co., Ltd., Suwon-si, Gyeonggi-do 16677 (KR)
(72) Inventor: LIM, Sunghwan, Suwon-si Gyeonggi-do 16677 (KR); LEE, Hojung, Suwon-si Gyeonggi-do 16677 (KR); CHO, Hyunmoon, Suwon-si Gyeonggi-do 16677 (KR)
(74) Representative: HGF
(86) International application number: PCT/KR2024/014896
(87) International publication number: WO 2025/095365

(57) **Abstract**

An electronic device according to one embodiment of the present disclosure may comprise: a first housing; a second housing; a flexible display panel including an area corresponding to the first housing and an area corresponding to the second housing; and a flexible cover structure disposed on the flexible display panel. The flexible cover structure can include: glass including a first area and a second area, which extends from the first area and corresponds to a bending or rolling area of the flexible display panel; a first coating layer disposed on at least a portion of the front surface of the glass; and a second coating layer disposed on the rear surface of the glass. At least a portion of the second area of the glass can be shaped to be bent in the direction toward the second coating layer.

## Description

### [Technical Field]

An embodiment disclosed in the disclosure relates to a flexible cover structure and an electronic device including the same.

### [Background Art]

Developing electronic information communication technology integrates various functionalities into a single electronic device or portable communication device. For example, smartphones pack the functionalities of a sound player, photographing device, and scheduler, as well as the communication functionality and, on top of that, may implement more various functions by having applications installed thereon.

As smartphones or other personal/portable communication devices spread, users' demand for portability and use convenience is on the rise. For example, a touchscreen display may not only serve as an output device of visual information but also provide a virtual keyboard that replaces a mechanical input device (e.g., a button input device). As such, portable communication devices or electronic devices may be made compact while delivering further enhanced applicability (e.g., a larger screen). Flexible displays, e.g., foldable or rollable displays, will come in commerce and electronic devices are expected to deliver better portability and use convenience.

The information described above may be provided as related art for the purpose of facilitating understanding of the disclosure. No claim or determination is made as to whether any of the foregoing is applicable as background art in relation to the disclosure.

### [Disclosure of Invention]

### [Solution to Problems]

An electronic device according to an embodiment of the disclosure may include a first housing, a second housing, a flexible display panel including an area corresponding to the first housing and an area corresponding to the second housing, and a flexible cover structure disposed on the flexible display panel. The flexible cover structure may include a glass including a first area and a second area extending from the first area and corresponding to a bending or rolling area of the flexible display panel, a first coating layer disposed over at least a portion of a front surface of the glass, and a second coating layer disposed on a rear surface of the glass. At least a portion of the second area of the glass may have a shape bent in a direction toward the second coating layer.

A flexible cover structure according to an embodiment of the disclosure may include a glass including a first area and a second area extending from the first area and corresponding to a bending or rolling area of a flexible display panel, a first coating layer disposed over at least a portion of a front surface of the glass, and a second coating layer disposed on a rear surface of the glass. At least a portion of the second area of the glass may have a shape bent in a direction toward the second coating layer.

However, the problems to be solved in the disclosure are not limited to the above-mentioned problems, and may be variously extended within a scope that does not depart from the spirit and scope of the disclosure.

### [Brief Description of Drawings]

FIG. 1 is a block diagram illustrating an electronic device in a network environment according to an embodiment of the disclosure.
FIG. 2A is a perspective view illustrating a foldable electronic device in an unfolded state according to an embodiment of the disclosure.
FIG. 2B is a perspective view illustrating a foldable electronic device in a folded state according to an embodiment of the disclosure.
FIG. 3 is an exploded perspective view illustrating a foldable electronic device according to an embodiment of the disclosure.
FIG. 4 is a cross-sectional view illustrating an unfolded state of an electronic device according to an embodiment of the disclosure.
FIG. 5 is a view illustrating a front surface of a flexible cover structure 400 in an unfolded state of an electronic device according to an embodiment of the disclosure.
FIG. 6 is a cross-sectional view illustrating the flexible cover structure 400 taken along line A-A' of FIG. 5 according to an embodiment of the disclosure.
FIG. 7A is a cross-sectional view illustrating the flexible cover structure 400 taken along line B-B' of FIG. 5 according to an embodiment of the disclosure.
FIG. 7B is a cross-sectional view illustrating the flexible cover structure 400 taken along line C-C' of FIG. 5 according to an embodiment of the disclosure.
FIG. 7C is a cross-sectional view illustrating the flexible cover structure 400 taken along line D-D' of FIG. 5 according to an embodiment of the disclosure.
FIG. 8 is a view for comparing a repulsive moment and stress difference between a flexible cover structure according to an embodiment of the disclosure and a general flexible cover structure (e.g., comparative experimental examples).
FIG. 9 is a view illustrating a front surface of a flexible cover structure 400a in an unfolded state of an electronic device according to an embodiment of the disclosure.
FIG. 10 is a cross-sectional view illustrating the flexible cover structure 400a taken along line A-A' of FIG. 9 according to an embodiment of the disclosure.
FIG. 11A is a cross-sectional view illustrating the flexible cover structure 400a taken along line B-B' of FIG. 9 according to an embodiment of the disclosure.
FIG. 11B is a cross-sectional view illustrating the flexible cover structure 400a taken along line C-C' of FIG. 9 according to an embodiment of the disclosure.
FIG. 11C is a cross-sectional view illustrating the flexible cover structure 400a taken along line D-D' of FIG. 9 according to an embodiment of the disclosure.
FIG. 12 is a view illustrating a front surface of a flexible cover structure 400b in an unfolded state of an electronic device according to an embodiment of the disclosure.
FIG. 13 is a cross-sectional view illustrating the flexible cover structure 400b taken along line A-A' of FIG. 12 according to an embodiment of the disclosure.
FIG. 14A is a cross-sectional view illustrating the flexible cover structure 400b taken along line B-B' of FIG. 12 according to an embodiment of the disclosure.
FIG. 14B is a cross-sectional view illustrating the flexible cover structure 400b taken along line C-C' of FIG. 12 according to an embodiment of the disclosure.
FIG. 14C is a cross-sectional view illustrating the flexible cover structure 400b taken along line D-D' of FIG. 12 according to an embodiment of the disclosure.
FIG. 15 is a view illustrating a front surface of a flexible cover structure 400c in an unfolded state of an electronic device according to an embodiment of the disclosure.
FIG. 16 is a cross-sectional view illustrating the flexible cover structure 400c taken along line A-A' of FIG. 15 according to an embodiment of the disclosure.
FIG. 17A is a cross-sectional view illustrating the flexible cover structure 400c taken along line B-B' of FIG. 15 according to an embodiment of the disclosure.
FIG. 17B is a cross-sectional view illustrating the flexible cover structure 400c taken along line C-C' of FIG. 15 according to an embodiment of the disclosure.
FIG. 17C is a cross-sectional view illustrating the flexible cover structure 400c taken along line D-D' of FIG. 15 according to an embodiment of the disclosure.
FIG. 18 is a cross-sectional view illustrating a flexible cover structure 400d taken along line A-A' of FIG. 5 according to an embodiment of the disclosure.
FIG. 19 is a cross-sectional view illustrating a flexible cover structure 400e taken along line A-A' of FIG. 5 according to an embodiment of the disclosure.
FIG. 20 is a cross-sectional view illustrating a flexible cover structure 400f taken along line A-A' of FIG. 9 according to an embodiment of the disclosure.
FIG. 21 is a cross-sectional view illustrating a flexible cover structure 400g taken along line A-A' of FIG. 9 according to an embodiment of the disclosure.
FIG. 22 is a cross-sectional view illustrating a flexible cover structure 400h taken along line A-A' of FIG. 5 according to an embodiment of the disclosure.
FIG. 23 is a view illustrating a pattern of a glass of a flexible cover structure according to an embodiment of the disclosure.
FIG. 24 is a flowchart illustrating a manufacturing process of a flexible cover structure according to an embodiment of the disclosure.
FIG. 25 is a view schematically illustrating a flow of a manufacturing process of a flexible cover structure according to an embodiment of the disclosure.
FIG. 26 is a flowchart illustrating a manufacturing process of a flexible cover structure according to an embodiment of the disclosure.
FIG. 27 is a view schematically illustrating a flow of a manufacturing process of a flexible cover structure according to an embodiment of the disclosure.
FIG. 28 is a view illustrating a front surface of a flexible cover structure 500, 500a in an unfolded state of an out-folding electronic device according to an embodiment of the disclosure.
FIG. 29 is a cross-sectional view illustrating the flexible cover structure 500 taken along line A-A' of FIG. 28 according to an embodiment of the disclosure.
FIG. 30 is a cross-sectional view illustrating the flexible cover structure 500a taken along line A-A' of FIG. 28 according to an embodiment of the disclosure.
FIG. 31 is a view illustrating a front surface of a flexible cover structure 600, 600a in an unfolded state of a slidable electronic device according to an embodiment of the disclosure.
FIG. 32 is a cross-sectional view illustrating the flexible cover structure 600 taken along line A-A' of FIG. 31 according to an embodiment of the disclosure.
FIG. 33 is a cross-sectional view illustrating the flexible cover structure 600a taken along line A-A' of FIG. 31 according to an embodiment of the disclosure.
FIG. 34 is a view illustrating a front surface of a flexible cover structure 700, 700a in an unfolded state of a multi-foldable electronic device according to an embodiment of the disclosure.
FIG. 35 is a cross-sectional view illustrating the flexible cover structure 700 taken along line A-A' of FIG. 34 according to an embodiment of the disclosure.
FIG. 36 is a cross-sectional view illustrating the flexible cover structure 700a taken along line A-A' of FIG. 34 according to an embodiment of the disclosure.
FIG. 37 is a view comparing repulsive moment and stress between a structure according to an embodiment of the disclosure and comparative structures.

### [Mode for the Invention]

The electronic device according to embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. In connection to the description of the drawings, similar reference numerals may be used for similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

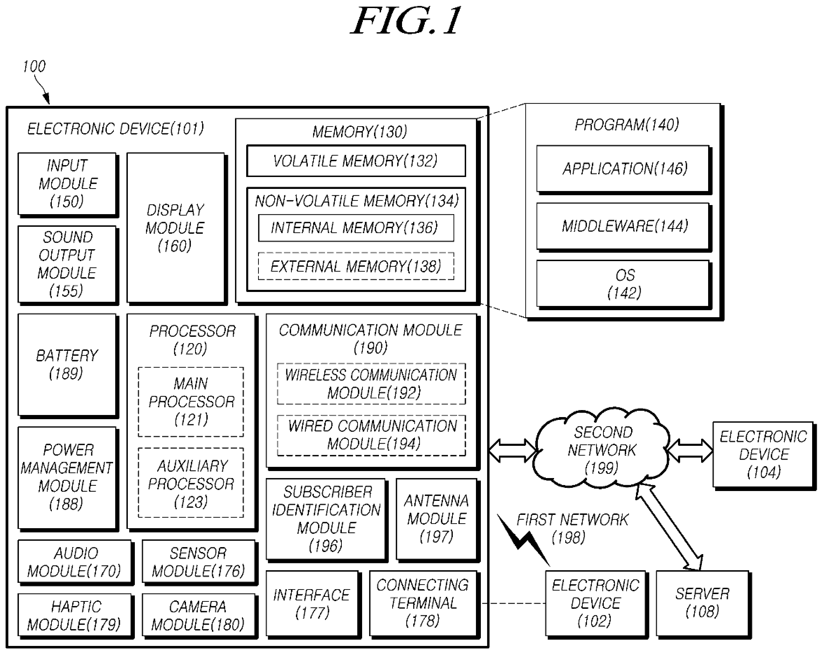

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in case that the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., the electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wiredly) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

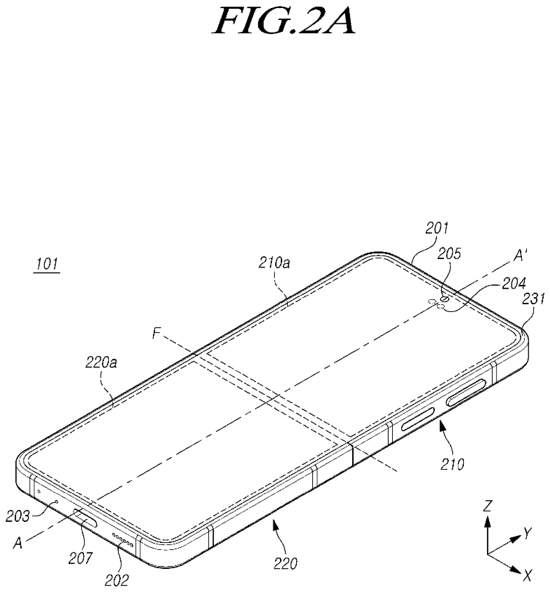

FIG. 2A is a perspective view illustrating a foldable electronic device in an unfolded state according to an embodiment of the disclosure;

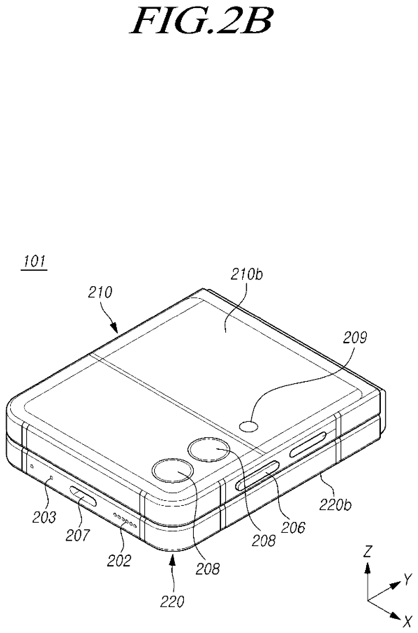

FIG. 2B is a perspective view illustrating a foldable electronic device in a folded state according to an embodiment of the disclosure.

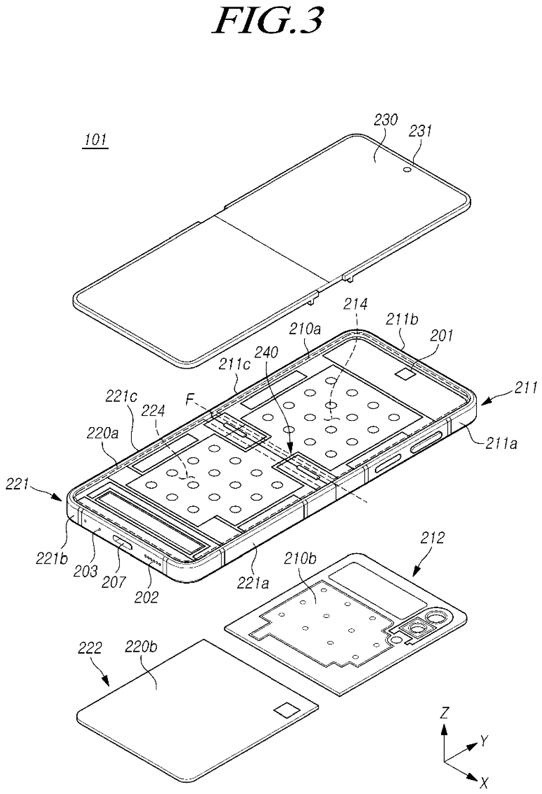

FIG. 3 is an exploded perspective view illustrating a foldable electronic device according to an embodiment of the disclosure.

The electronic device shown in FIGS. 2A to 3 is for illustrative purposes only, and the disclosure is not limited by the drawings. The XYZ coordinate system shown in FIGS. 2A to 3 is for illustrative purposes of describing the layout of the components and does not limit the scope of the claims.

According to an embodiment, the electronic device 101 (e.g., the electronic device 101 of FIG. 1) may include at least one pair of housings 210 and 220. The pair of housings 210 and 220 may be rotatably coupled to fold about, e.g., a hinge (e.g., the hinge 240 of FIG. 3) while facing each other.

According to an embodiment, the pair of housings 210 and 220 may include a first housing 210 and a second housing 220. The first housing 210 and the second housing 220 may be disposed on two opposite sides of the folding axis F. One end area of the first housing 210 and one end area of the second housing 220 may be disposed side by side with the hinge 240 interposed therebetween. The first housing 210 and the second housing 220 may have symmetrical shapes with respect to a plane including the folding axis F and extending in the Z-axis direction. The folding axis F may be an axis extending in the X1 direction, formed by the hinge 240.

According to an embodiment, the first housing 210 may have substantially the same length as the second housing 220 (e.g., length in the Y-axis direction), but is not limited thereto. The first housing 210 may have substantially the same width as the second housing 220 (e.g., width in the X-axis direction), but is not limited thereto.

Hereinafter, 'unfolding state (or flat state)' or 'unfolded state' may refer to a state in which the angle between the first housing 210 and the second housing 220 is substantially 180 degrees. 'Folding state' or a 'folded state' may refer to a state in which the angle formed between the first housing 210 and the second housing 220 is substantially 0 degrees. 'Intermediate state' may refer to any state between the unfolding state and the folding state. According to an embodiment, the electronic device 101 may rotate about the hinge 240 such that the first housing 210 and the second housing 220 form an angle from 0 degrees to 180 degrees. According to an embodiment, the electronic device 101 may rotate about the hinge 240 such that the first housing 210 and the second housing 220 form an angle from 180 degrees to 360 degrees.

According to an embodiment, the first housing 210 may include a first surface 210a and a second surface 210b. For example, the first surface 210a may be provided to face in a first direction (e.g., +Z-axis direction). The first surface 210a may be, e.g., a surface on which at least a portion of the flexible display 230 is disposed. The first surface 210a may refer to, e.g., a virtual surface overlapping at least a portion of the flexible display 230. For example, the second surface 210b may be provided to face in a second direction (e.g., -Z-axis direction). The second surface 210b may be, e.g., a surface on which the display 280 is disposed. The second surface 210b may be, e.g., a surface on which the first rear cover 212 is disposed. The second surface 210b may be parallel to the first surface 210a. The second surface 210b may refer to a plane defined by, e.g., the first rear cover 212.

According to an embodiment, the second housing 220 may include a third surface 220a and a fourth surface 220b. For example, the third surface 220a may be provided to face in the first direction (e.g., +Z-axis direction). The third surface 220a may be, e.g., a surface on which at least a portion of the flexible display 230 is disposed. The third surface 220a may refer to, e.g., a virtual surface overlapping at least a portion of the flexible display 230. For example, the fourth surface 220b may be provided to face in a second direction (e.g., -Z-axis direction). The fourth surface 220b may be, e.g., a surface on which the second rear cover 222 is disposed. The fourth surface 220b may be parallel to the third surface 220a. The fourth surface 220b may refer to a plane defined by, e.g., the second rear cover 222.

According to an embodiment, when the electronic device 101 is unfolded, the first surface 210a and the third surface 220a may be positioned within one arbitrary virtual plane (e.g., an XY plane). For example, the first surface 210a and the third surface 220a may form the same plane when the electronic device 101 is unfolded. For example, the first surface 210a and the third surface 220a may be disposed to form 180 degrees with respect to the XY plane in the unfolded state. When the electronic device 101 is unfolded, the second surface 210b and the fourth surface 220b may be positioned within another arbitrary virtual plane (e.g., an XY plane). For example, the second surface 210b and the fourth surface 220b may form the same plane in the unfolded state of the electronic device 101. For example, the second surface 210b and the fourth surface 220b may be disposed to form 180 degrees with respect to the XY plane in the unfolded state.

According to an embodiment, in the folded state of the electronic device 101, at least a portion of the first surface 210a and at least a portion of the third surface 220a may face each other. For example, in the folded state of the electronic device 101, the angle between the first surface 210a and the third surface 220a may be 0 degrees from the XY plane. As the electronic device 101 is folded from the unfolded state, the angle between the first surface 210a and the third surface 220a from the XY plane may gradually decrease. For example, the angle formed between the first surface 210a and the third surfaces 220a from the XY plane in the intermediate state may be determined between about 0 degrees and about 180 degrees. In the folded state of the electronic device 101, the second surface 210b and the fourth surface 220b may be parallel to each other. For example, the second surface 210b and the fourth surface 220b may face in opposite directions in the folded state of the electronic device 101.

According to an embodiment, the pair of housings 210 and 220 included in the electronic device 101 is not limited to the shape and coupling shown but may rather be implemented in other shapes or via a combination and/or coupling of other components.

According to an embodiment, the first housing 210 may include a first side frame 211. The first side frame 211 may constitute a side surface of the first housing 210. The first side frame 211 may form part of the exterior of the first housing 210. The first side frame 211 may be provided to protect components received inside the electronic device 101 from the outside.

According to an embodiment, the first side frame 211 may include a first side member 211a, a second side member 211b, and/or a third side member 211c. The first side member 211a may have a first length along a first length direction (e.g., Y-axis direction). The second side member 211b may extend from the first side member 211a in a substantially vertical direction (e.g., the X-axis direction). The second side member 211b may extend to have a second length equal to or different from the first length. The third side member 211c may extend from the second side member 211b in a substantially vertical direction (e.g., the Y-axis direction). The third side member 211c may extend in a direction substantially parallel to the first side member 211a. The third side member 211c may have a first length along the first length direction (e.g., Y-axis direction).

According to an embodiment, the first side member 211a, the second side member 211b, and the third side member 211c may be disposed to be visible from the outside. At least a portion of the first side member 211a, the second side member 211b, and/or the third side member 211c may be formed of a curved surface. The first side frame 211 may be formed in a rectangular (e.g., square or rectangular) shape by the first side member 211a, the second side member 211b, and the third side member 211c. The first side member 211a, the second side member 211b, and the third side member 211c may be integrally formed, but are not limited thereto.

According to an embodiment, the second housing 220 may include a second side frame 221. The second side frame 221 may constitute a side surface of the second housing 220. The second side frame 221 may form part of the exterior of the first housing 210. The second side frame 221 may be provided to protect components received inside the electronic device 101 from the outside.

According to an embodiment, the second side frame 221 may include a fourth side member 221a, a fifth side member 221b, and/or a sixth side member 221c. The fourth side member 221a may have a third length along a first length direction (e.g., Y-axis direction). The fifth side member 221b may extend from the fourth side member 221a in a substantially vertical direction (e.g., the X-axis direction). The fifth side member 221b may extend to have a fourth length equal to or different from the third length. The sixth side member 221c may extend from the fifth side member 221b in a substantially vertical direction (e.g., the Y-axis direction). The sixth side member 221c may extend in a direction substantially parallel to the fourth side member 221a. The sixth side member 221c may have a third length along the first length direction (e.g., Y-axis direction).

According to an embodiment, the fourth side member 221a, the fifth side member 221b, and the sixth side member 221c may be disposed to be visible from the outside. At least a portion of the fourth side member 221a, the fifth side member 221b, and/or the sixth side member 221c may be formed of a curved surface. The second side frame 221 may be formed in a rectangular (e.g., square or rectangular) shape by the fourth side member 221a, the fifth side member 221b, and the sixth side member 221c. The first length may be substantially equal to the third length. The second length may be substantially equal to the fourth length. The fourth side member 221a, the fifth side member 221b, and the sixth side member 221c may be integrally formed, but are not limited thereto.

According to an embodiment, in the unfolded state of the electronic device 101, the first side member 211a and the fourth side member 221a may be positioned substantially in a straight line. In the unfolded state of the electronic device 101, the second side member 211b and the fifth side member 221b may be parallel to each other. In the unfolded state of the electronic device 101, the third side member 211c and the sixth side member 221c may be positioned substantially in a straight line.

According to an embodiment, in the folded state of the electronic device 101, the first side member 211a and the fourth side member 221a may overlap each other. In the folded state of the electronic device 101, the second side member 211b and the fifth side member 221b may overlap each other. In the folded state of the electronic device 101, the third side member 211c and the sixth side member 221c may overlap each other.

According to an embodiment, the first housing 210 may include a first rear cover 212. The first rear cover 212 may form at least a portion of the second surface 210b of the first housing 210. The first rear cover 212 may be combined with the first side frame 211. The first rear cover 212 may be integrally formed with, e.g., the first side frame 211.

According to an embodiment, the second housing 220 may include a second rear cover 222. The second rear cover 222 may form at least a portion of the fourth surface 220b of the second housing 220. The second rear cover 222 may be combined with the second side frame 221. The second rear cover 222 may be integrally formed with, e.g., the second side frame 221.

According to an embodiment, the first rear cover 212 and/or the second rear cover 222 may be formed of at least one of laminated or colored glass, ceramic, Glastic, polymer, or metal (e.g., aluminum, stainless steel (STS), or magnesium), or a combination thereof.

According to an embodiment, the electronic device 101 may include a flexible display 230 (e.g., a foldable display or a display). The flexible display 230 may be disposed across the first housing 210, the hinge 240 and the second housing 220. The flexible display 230 may be disposed from the first surface 210a of the first housing 210 across the hinge structure 240 up to at least a portion of the third surface 220a of the second housing 220. The flexible display 230 may be disposed so that the first surface 210a of the first housing 210 and/or the third surface 220a of the second housing 220 overlap. A portion of the flexible display 230 corresponding to the hinge 240 may be bent according to the rotation of the hinge 240.

According to an embodiment, in the unfolded state, the flexible display 230 may be disposed to be visible from the outside. In a folding state, the flexible display 230 may be disposed to be invisible from the outside.

According to an embodiment, the electronic device 101 may include a protective cover 231. The protective cover 231 may be positioned to protect an edge portion of the flexible display 230. The protective cover 231 may form part of the exterior of the electronic device 101.

According to an embodiment, the electronic device 101 may include at least one of an input device (e.g., the microphone 203), a sound output device (e.g., the receiver 201 for phone calls or speaker 202), sensor modules 204, a camera module (the first camera module 205 or second camera module 208), a connector port 207, a key input device (not shown), or an indicator (not shown), disposed in the first inner space 214 of the first housing 210 or the second inner space 224 of the second housing 220. The electronic device 101 may be configured to omit at least one of the above-described components or add other components.

According to an embodiment, the input device may include a plurality of microphones disposed to detect the direction of sound. The sound output device may include, e.g., the receiver 201 for phone calls and the speaker 202. The sound output devices 201 and 202 may be disposed to face the outside through at least one speaker hole formed in the first housing 210 or the second housing 220. The connector port 207 may be disposed to face the outside through a connector port hole formed in the first housing 210 or the second housing 220.

According to an embodiment, the sensor module 204 may generate an electrical signal or a data value corresponding to an internal operating state of the electronic device 101 or an external environmental state. The sensor module 204 may include at least one of a proximity sensor, an illuminance sensor, a time of flight (TOF) sensor, an ultrasonic sensor, a fingerprint recognition sensor, a gesture sensor, a gyro sensor, an air pressure sensor, a magnetic sensor, an accelerometer, a grip sensor, a color sensor, an infrared (IR) sensor, a biometric sensor, a temperature sensor, or a humidity sensor.

According to an embodiment, the camera module may include a first camera module 205 disposed on the front (e.g., surface in the +Z-axis direction) of the electronic device 101 or a second camera module 208 disposed on the rear surface (e.g., surface in the -Z-axis direction) of the electronic device 200. The first camera module 205 and/or the second camera module 208 may include one or more lenses, an image sensor, and/or an image signal processor. For example, the first camera module 205 may be disposed under the flexible display 230 and be configured to capture a subject through a portion of the active area of the flexible display 230. The flash 209 may be disposed on the second camera module 208. The flash 209 may include, e.g., a light emitting diode (LED) or a xenon lamp.

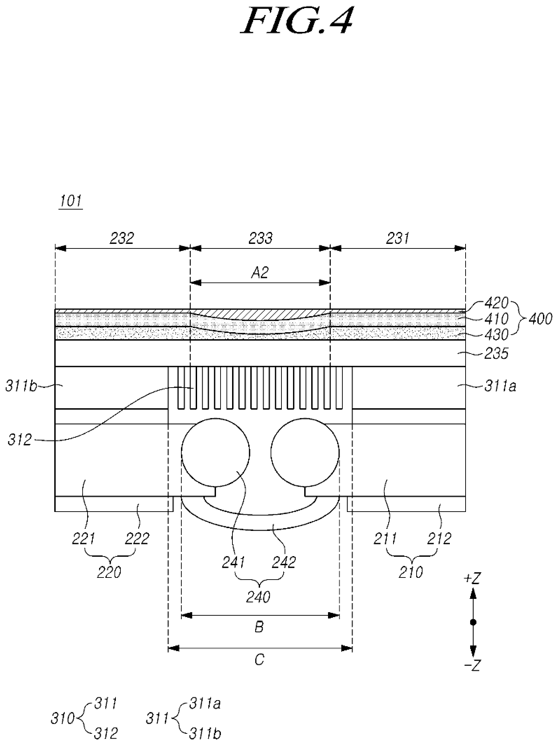

FIG. 4 is a cross-sectional view illustrating an unfolded state of an electronic device according to an embodiment of the disclosure.

FIG. 4 is a cross-sectional view illustrating the electronic device 101 in an unfolded state of FIG. 2A taken in the A-A' direction.

According to an embodiment, an electronic device (e.g., the electronic device 101 of FIGS. 1 to 3) may include a first housing 210 (e.g., the first housing 210 of FIGS. 2A and 3), a second housing 220 (e.g., the second housing 220 of FIGS. 2A and 3), a hinge structure 240 (e.g., the hinge 240 of FIGS. 2A and 3), a support structure 310, and a flexible display 230.

According to an embodiment, according to a state of the electronic device 101 (e.g., from a flat state or an unfolded state to a folded state), the flexible display 230 may vary to an unfolded state, an intermediate state, or a folded state.

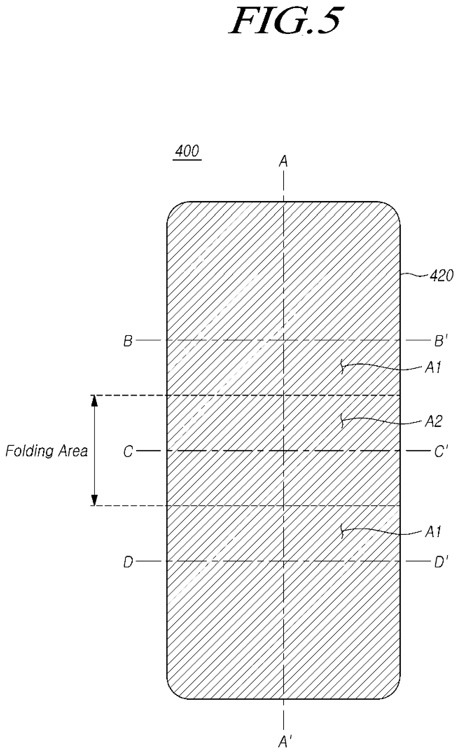

The configuration of the first housing 210, the second housing 220, the hinge structure 240, and the flexible display 230 of FIG. 4 may be identical in whole or in portion to the configuration of the first housing 210, the second housing 220, the hinge 240, and the flexible display 230 of FIGS. 2A to 4. The structure of FIG. 4 may be selectively combinable with the structure of FIGS. 2A to 3 and the structure of FIGS. 5 to 36.

According to an embodiment, the hinge structure 240 may include a hinge assembly 241 and a hinge cover 242 covering the hinge assembly 241. The hinge assembly 241 may rotatably couple the first housing 210 and the second housing 220 to each other. For example, the hinge assembly 241 may include a dual hinge axis. One axis of the dual hinge axis and a surrounding area thereof may be coupled to the first housing 210, and the other axis and a surrounding area thereof may be coupled to the second housing 220. The hinge assembly 241 may be named as at least one of a moving module, a rotation module, or a pivoting module.

According to an embodiment, at least a portion of the hinge cover 242 may be disposed between the first housing 210 and the second housing 220. According to an embodiment, the hinge cover 242 may be covered by a portion of the first housing 210 and the second housing 220 or may be exposed to an outside of the electronic device 101 according to the state of the electronic device 101. According to an embodiment, the hinge cover 242 may protect the hinge assembly 241 from an external impact of the electronic device 101. According to an embodiment, the hinge cover 242 may be named (or referred to) as a hinge housing.

According to an embodiment, as illustrated in FIG. 2A, when the electronic device 101 is in an unfolded state, the hinge cover 242 may be covered by the first housing 210 and the second housing 220 and may not be exposed. According to an embodiment, as illustrated in FIG. 2B, when the electronic device 101 is in a folded state (e.g., a fully folded state), the hinge cover 242 may be exposed to the outside between the first housing 210 and the second housing 220. According to an embodiment, in an intermediate state in which the first housing 210 and the second housing 220 are folded with a certain angle, the hinge cover 242 may be partially exposed to the outside between the first housing 210 and the second housing 220. However, in this case, an exposed area may be smaller than that in the fully folded state. According to an embodiment, the hinge cover 242 may include a curved surface.

According to an embodiment, the support structure 310 may be disposed below the flexible display 230 and may support the flexible display 230. The support structure 310 may include a flexible metal material. The support structure 310 may include a flat area 311 and a bending area 312 extending from the flat area 311 and corresponding to a bending or rolling area of the flexible display 230. The bending area 312 may be named as a pattern area in which a pattern is formed, or a lattice area. The flat area 311 may include a first flat area 311a and a second flat area 311b spaced apart from each other with the bending area 312 therebetween.

According to an embodiment, the bending area 312 of the support structure 310 may include a pattern having a repeated shape. The pattern may include at least one of a plurality of holes, a plurality of recesses, or a plurality of openings. The shape of the pattern may be variously modified for easy bending or rolling of the flexible display 230.

According to an embodiment, the flexible display 230 may include a flexible display panel 235 and a flexible cover structure 400 formed such that at least a portion thereof is exposed to the outside to protect the flexible display panel 235.

According to an embodiment, the flexible display 230 is configured to be unfolded or bent (e.g., folded) or rolled based on a relative movement of the first housing 210 or the second housing 220, and may include a first display area 231 connected to the first housing 210, a second display area 232 connected to the second housing 220, and a folding area 233 connecting the first display area 231 and the second display area 232.

According to an embodiment, the folding area 233 may be positioned over the hinge structure 240 when the electronic device 101 is in an unfolded state. For example, the folding area 233 may face at least a portion of the hinge structure 240. According to an embodiment, the folding area 233 may be referred to as a portion of the flexible display 230 in which at least a portion thereof is bent based on a state change (e.g., folding or unfolding) of the electronic device 101. According to an embodiment, the first display area 231 may be disposed on the first housing 210, and the second display area 232 may be disposed on the second housing 220. According to an embodiment, at least a portion of the flexible display 230 may be received in the first housing 210 and the second housing 220.

According to an embodiment, the flexible display panel 235 may visually provide information to an outside (e.g., a user) of the electronic device 101. The display panel 235 may include, e.g., a hologram device, or a projector and a control circuit for controlling the device. According to an embodiment, the flexible display 230 may include a touch sensor configured to sense a touch or a pressure sensor configured to measure an intensity of a force generated by the touch.

According to an embodiment, the flexible cover structure 400 may form a stacked structure to protect the display panel 235. The flexible cover structure 400 may include a glass 410, a first coating layer 420 disposed on the glass 410, and a second coating layer 430 disposed below the glass 410.

According to an embodiment, the flexible cover structure 400 may provide a bending section A2 corresponding to the folding area 233 of the flexible display 230 in a bent shape. The bending section A2 may be named as a forming section of the glass 410. Due to the bending section A2 of the flexible cover structure 400, a repulsive force of the flexible display 230 may be decreased and impact resistance performance may be enhanced in a folded state (or an intermediate state) of the electronic device 101. A detailed description of the flexible cover structure 400 is described below.

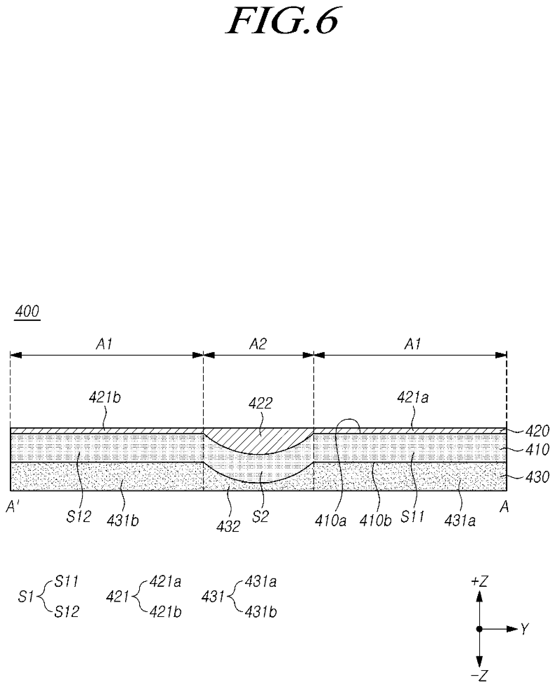

According to an embodiment, the bending section A2 of the flexible cover structure 400 (e.g., the second area of the glass 410 (e.g., the second area S2 of FIGS. 5 to 7C)) may be designed to have a length corresponding to a width B of the hinge assembly 241. The width B of the hinge assembly 241 may be defined as a distance between outermost edges of the hinge assembly structure. For example, the bending section A2 of the flexible cover structure 400 (e.g., a width of the second area S2 of the glass 410 of FIG. 6) may have a length of about 10% to 200% of the width B of the hinge assembly 241. For example, the bending section A2 of the flexible cover structure 400 (e.g., the width of the second area S2 of the glass 410 of FIG. 6) may have a length equal to or smaller than the width B of the hinge assembly 241. Based on an in-folding electronic device, the bending section A2 of the flexible cover structure 400 may have a length of about 10% to 100% of the width B of the hinge assembly 241. For example, the bending section A2 of the flexible cover structure 400 (e.g., the width of the second area S2 of the glass 410 of FIG. 6) may have a length equal to or greater than the width B of the hinge assembly 241. Based on an out-folding electronic device, the bending section A2 of the flexible cover structure 400 may have a length of about 100% to 200% of the width B of the hinge assembly 241. According to an embodiment, the bending section A2 of the flexible cover structure 400 (e.g., the second area of the glass 410 (e.g., the second area S2 of FIGS. 5 to 7C)) may be designed to have a length corresponding to a bending width C of the support structure 310. The bending width C of the support structure 310 may be defined as a distance between outermost edges of the bending area 312 of the support structure 310. For example, the bending section A2 of the flexible cover structure 400 may have a length smaller than the bending width C of the support structure 310.

According to an embodiment, the width B of the hinge assembly 241 may be understood differently according to a design structure. For example, if the width B of the hinge assembly 241 is determined based on a distance between outermost edges of a biaxial hinge module, the width B of the hinge assembly 241 may have a length smaller than the bending width C of the support structure 310. For example, if the hinge assembly 241 includes a hinge plate extending further toward the housing 210, 220 side than the biaxial hinge module, and the width B of the hinge assembly 241 is determined based on a distance between outermost edges of the hinge plates, the width B of the hinge assembly 241 may have a length longer than the bending width C of the support structure 310.

FIG. 5 is a view illustrating a front surface of a flexible cover structure 400 in an unfolded state of an electronic device according to an embodiment of the disclosure.

FIG. 6 is a cross-sectional view illustrating the flexible cover structure 400 taken along line A-A' of FIG. 5 according to an embodiment of the disclosure.

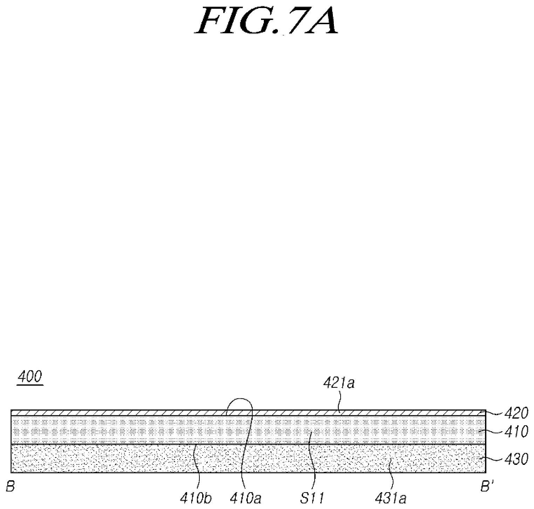

FIG. 7A is a cross-sectional view illustrating the flexible cover structure 400 taken along line B-B' of FIG. 5 according to an embodiment of the disclosure.

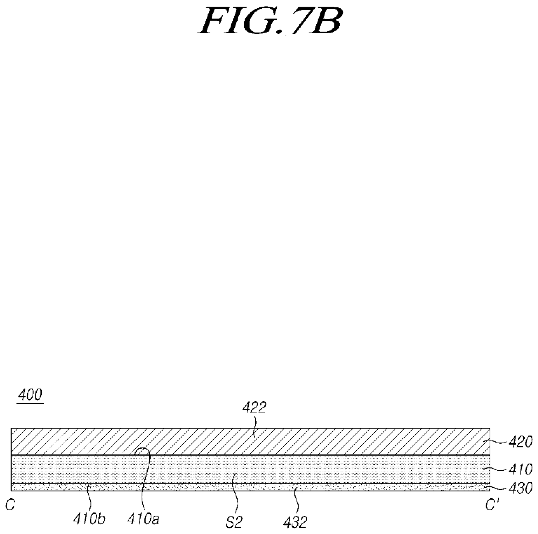

FIG. 7B is a cross-sectional view illustrating the flexible cover structure 400 taken along line C-C' of FIG. 5 according to an embodiment of the disclosure.

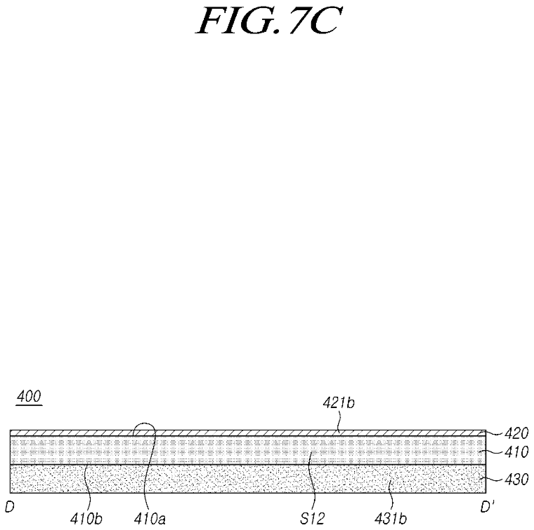

FIG. 7C is a cross-sectional view illustrating the flexible cover structure 400 taken along line D-D' of FIG. 5 according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400 formed such that at least a portion thereof is exposed to the outside to protect the flexible display panel.

According to an embodiment, according to a state of the electronic device 101 (e.g., from a flat state or an unfolded state to a folded state), the flexible display 230 may vary to an unfolded state, an intermediate state, or a folded state. According to an embodiment, the flexible cover structure 400 may be a flexible structure to correspond to operations of the unfolded state, the intermediate state, and the folded state of the flexible display 230. For example, at least a portion of the flexible cover structure 400 may vary from an area forming a plane to an area forming bending (or rolling) when the electronic device operates in a folded state.

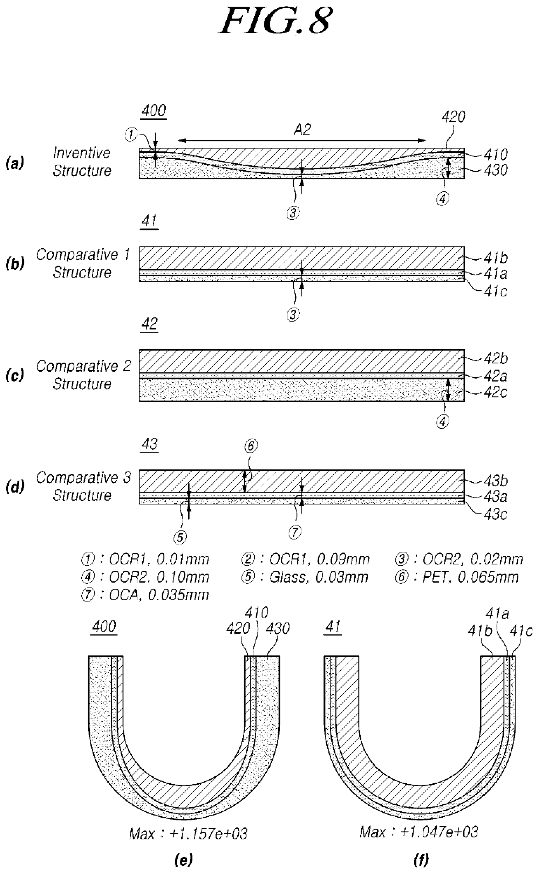

The configuration of the flexible cover structure 400 of FIGS. 5 to 7C may be identical in portion or in whole to the configuration of the flexible display 230 of FIGS. 2A to 4. The embodiments of FIGS. 5 to 7C may be partially combined with the embodiments of FIGS. 1 to 4 and/or the embodiments of FIGS. 8 to 36.

According to an embodiment, the flexible cover structure 400 of an electronic device (e.g., the electronic device 101 of FIGS. 1 to 3) may be named as a window cover or a cover structure. The flexible cover structure 400 may include a glass 410, a first coating layer 420 disposed on the glass 410, and a second coating layer 430 disposed below the glass 410.

According to an embodiment, the cover structure 400 may include a flat section A1 corresponding to a flat area of the flexible display panel and a bending section A2 corresponding to a bending or rolling area of the flexible display panel. The first coating layer 420, the glass 410, and the second coating layer 430 forming the bending section A2 of the cover structure 400 may vary according to a state of the electronic device 101 (e.g., from a flat state or an unfolded state to a folded state). A sum of thicknesses of the first coating layer 420, the glass 410, and the second coating layer 430 forming the bending section A2 of the cover structure 400 may be substantially equal to a sum of thicknesses of the first coating layer 420, the glass 410, and the second coating layer 430 forming the flat section A1 of the cover structure 400.

According to an embodiment, the glass 410 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween. For example, the first area S1 of the glass 410 (e.g., the 1-1th area S11 and the 1-2th area S12) may be a portion of or a structure corresponding to a first display area (e.g., the first display area 231 of FIG. 4) and a second display area (e.g., the second display area 232 of FIG. 4). The second area S2 of the glass 410 may be a portion of or a structure corresponding to a folding area (e.g., the folding area 233 of FIG. 4). For example, in case that the flexible display 230 is defined as being limited to the flexible display panel, the 1-1th area S11 of the glass 410 may be disposed on the first display area 231, the 1-2th area S12 of the glass 410 may be disposed on the second display area 232, and the second area S2 of the glass 410 may be disposed on the folding area 233.

According to an embodiment, the glass 410 may include the first area S1 and the second area S2, and the first area S1 and the second area S2 may form an overall uniform thickness (e.g., the same thickness). In general, in case that a glass is manufactured to have different thicknesses in a partial area through a processing process (e.g., a processing process such as CNC, etching, or polishing), wrinkles or shape changes may occur around the processed partial area, or a crack may occur due to weakened strength. According to an embodiment, the glass 410 may provide an overall uniform thickness (e.g., the same thickness) through chemical processing (e.g., etching), and may reduce or limit occurrence of defects in a partial area. The cover structure 400 may provide a variable structure (e.g., a curved shape and/or a pattern shape) to a bending/rolling area (e.g., the second area S2) of the glass 410 to correspond to bending or rolling of the flexible display 230.

According to an embodiment, the glass 410 may include a front surface 410a (e.g., a side facing the +Z-axis direction) and a rear surface 410b (e.g., a side facing the -Z axis), the first coating layer 420 may be disposed on the front surface 410a, and the second coating layer 430 may be disposed on the rear surface 410b.

According to an embodiment, the first area S1 of the glass 410 may have an overall uniform thickness (e.g., the same thickness). For example, a thickness of the 1-1th area S11 and a thickness of the 1-2th area S12 may be substantially the same. The first area S1 of the glass 410 may maintain a plane that does not bend or roll because it is a portion of or a structure corresponding to a flat area of the flexible display (e.g., the first display area 231 and the second display area 332 of FIG. 4).

According to an embodiment, the second area S2 of the glass 410 may have a shape bent in a direction toward the second coating layer 430. According to an embodiment, the second area S2 of the glass 410 may have a shape bent in a direction toward the display panel (e.g., the display panel 235 of FIG. 4). For example, the front surface 410a of the second area S2 may be formed to be concave with respect to the front surface 410a of the first area S1 (e.g., the 1-1th area S11 and the 1-2th area S12), and the rear surface 410b of the second area S2 may be formed to be convex with respect to the rear surface 410b of the first area S1 (e.g., the 1-1th area S11 and the 1-2th area S12). For example, the front surface 410a of the second area S2 may form a curved surface bent in the -Z-axis direction compared to the front surface 410a of the first area S1 (e.g., the 1-1th area S11 and the 1-2th area S12), and the rear surface 410b of the second area S2 may form a curved surface bent in the -Z-axis direction compared to the rear surface 410b of the first area S1 (e.g., the 1-1th area S11 and the 1-2th area S12).

According to an embodiment, in case of being viewed toward the front surface of the glass 410, the second area S2 of the glass 410 may have a shape recessed in a direction of the second coating layer 430 with respect to the first area S1. According to an embodiment, in case of being viewed toward the rear surface of the glass 410, the second area S2 of the glass 410 may have a shape protruding in a direction of the second coating layer 430 with respect to the first area S1.

According to an embodiment, a thickness of the second area S2 of the glass 410 may be substantially the same as a thickness of the first area S1. A thickness of the glass 410 may be about 20 µm or more as a whole. For example, the thickness of the glass 410 may be about 30 µm to 200 µm as a whole. This was set to a thickness having a stress value of less than about 1.5 GPa based on a maximum stress applied to the glass 410 when the glass 410 is bent at 1.8R (curvature).

According to an embodiment, referring to the cross-section of FIG. 6, the second area S2 of the glass 410 may have a symmetrical shape with respect to a folding axis (e.g., line C-C' of FIG. 5). A value (e.g., an absolute value) of a slope (e.g., a slope of a tangent line) of the front surface 410a and/or the rear surface 410b of the second area S2 of the glass 410 may gradually (or sequentially) increase away from the folding axis (e.g., line C-C' of FIG. 5). For example, the value of the slope (e.g., the slope of the tangent line) of the front surface 410a and/or the rear surface 410b of the second area S2 may increase toward an area adjacent to the 1-1th area S11 based on the folding axis (e.g., line C-C' of FIG. 5). For example, the value of the slope (e.g., the slope of the tangent line) of the front surface 410a and/or the rear surface 410b of the second area S2 may increase toward an area adjacent to the 1-2th area S12 based on the folding axis (e.g., line C-C' of FIG. 5).

According to an embodiment, the first coating layer 420 may be disposed on the glass 410 (e.g., on the front surface 410a). The first coating layer 420 may include a first portion 421 disposed on the first area S1 of the glass 410 and a second portion 422 disposed on the second area S2 of the glass 410. The first portion 421 of the first coating layer 420 may include a 1-1th portion 421a and a 1-2th portion 421b, wherein the 1-1th portion 421a may correspond to the 1-1th area S11 of the glass 410, and the 1-2th portion 421b may correspond to the 1-2th area S12 of the glass 410. The second portion 422 of the first coating layer 420 may correspond to a bending or rolling area of the flexible display (e.g., the second area S2 of the glass 410). For example, the second portion 422 of the first coating layer 420 may be a portion of or a structure corresponding to a folding area of the flexible display (e.g., the folding area 233 of FIG. 4).

According to an embodiment, the first coating layer 620 may be a structure whose shape varies along a long length direction (e.g., Y-axis direction). The first portion 421 and the second portion 422 of the first coating layer 620 may have different shapes. For example, a thickness of the first portion 421 and a thickness of the second portion 422 may be different.

According to an embodiment, at least a portion of the second portion 422 of the first coating layer 420 may have a shape bent in a direction toward the glass 410. For example, a rear surface (e.g., a side facing the -Z axis) of the second portion 422 may be formed to be convex with respect to a rear surface (e.g., a side facing the -Z axis) of the first portion 421 (e.g., the 1-1th portion 421a and the 1-2th portion 421b). For example, the rear surface of the second portion 422 may form a curved surface bent in the -Z-axis direction compared to the rear surface of the first portion 421 (e.g., the 1-1th portion 421a and the 1-2th portion 421b). For example, in case of being viewed toward the rear surface of the first coating layer 420, the second portion 422 of the first coating layer 420 may have a shape protruding in a direction of the glass 410 with respect to the first portion 421. A front surface (e.g., a side facing the +Z axis) of the second portion 422 may extend to form a flat surface with a front surface (e.g., a side facing the +Z axis) of the first portion 421 (e.g., the 1-1th portion 421a and the 1-2th portion 421b).

According to an embodiment, the first portion 421 of the first coating layer 420 may have an overall uniform thickness (e.g., the same thickness). For example, a thickness of the 1-1th portion 421a and a thickness of the 1-2th portion 421b may be substantially the same. The first portion 421 of the first coating layer 420 may maintain a plane that does not bend or roll because it is a portion of or a structure corresponding to a flat area of the flexible display (e.g., the first display area 231 and the second display area 332 of FIG. 4).

According to an embodiment, a thickness of the second portion 422 of the first coating layer 420 may be substantially different from a thickness of the first portion 421. For example, the thickness of the second portion 422 of the first coating layer 420 may be greater than the thickness of the first portion 421.

According to an embodiment, the second portion 422 of the first coating layer 420 may be provided in a shape corresponding to the second area S2 of the glass 410. For example, in case that the front surface 410a of the second area S2 of the glass 410 has a concave (or recessed) shape, the second portion 422 of the first coating layer 420 may be a structure filling the concave shape.

Referring to the cross-section of FIG. 6, the second portion 422 of the first coating layer 420 may have a symmetrical shape with respect to a folding axis (e.g., line C-C' of FIG. 5). A value (e.g., an absolute value) of a slope (e.g., a slope of a tangent line) of a rear surface of the second portion 422 of the first coating layer 420 may gradually (or sequentially) increase away from the folding axis (e.g., line C-C' of FIG. 5). For example, the value of the slope (e.g., the slope of the tangent line) of the rear surface of the second portion 422 may increase toward an area adjacent to the 1-1th portion 421a based on the folding axis (e.g., line C-C' of FIG. 5). For example, the value of the slope (e.g., the slope of the tangent line) of the rear surface of the second portion 422 may increase toward an area adjacent to the 1-2th portion 421b based on the folding axis (e.g., line C-C' of FIG. 5).

According to an embodiment, as the front surface of the first coating layer 420 forms an overall flat surface, a thickness of the second portion 422 may gradually (or sequentially) decrease away from the folding axis (e.g., line C-C' of FIG. 5). For example, the thickness of the second portion 422 may decrease toward an area adjacent to the 1-1th portion 421a based on the folding axis (e.g., line C-C' of FIG. 5). For example, the thickness of the second portion 422 may decrease toward an area adjacent to the 1-2th portion 421b based on the folding axis (e.g., line C-C' of FIG. 5).

According to an embodiment, the first coating layer 420 may be a film layer composed of a transparent polymer. The first coating layer 420 may include an optically clear resin (OCR) filler. The OCR filler may have substantially the same refractive index as the glass 410 (e.g., a refractive index of 0.05R or more). The OCR filler may be an elastic material including an adhesive component. For example, the OCR filler may be natural rubber, styrene butadiene rubber, styreneisoprene-styrene (co)polymer, styrene-butadiene-styrene (co)polymer, (meth)acrylic (co)polymer, polyacrylate, polyolefin, polyisobutylene and polyisoprene, polyurethane, polyvinyl ethyl ether, polysiloxane, silicone, polyurea, or a mixture of at least one thereof.

According to an embodiment, the first coating layer 420 may be a material including an adhesive component. The first coating layer 420 may include at least one of optical clear adhesive (OCA), pressure sensitive adhesive (PSA), thermal reactive adhesive, general adhesive, or double-sided tape.

According to an embodiment, the first coating layer 420 may have a greater modulus than the second coating layer 430. For example, the modulus of the first coating layer 420 may be about 480 MPa to 720 MPa. For example, the modulus of the first coating layer 420 may be about 600 MPa. According to an embodiment, an additive (e.g., a crosslinking agent, a curing agent), heat, and/or light (e.g., ultraviolet, radiation) irradiation amount may be adjusted to control a modulus property value of the first coating layer 420. By adjusting the corresponding factor (e.g., additive, heat, and/or light), an average molecular weight (Mn) or a degree of polymerization of the first coating layer 420 may be controlled, and thus, a property value desired by an operator may be obtained. For example, as the amount of the additive increases or as the heat/ultraviolet/radiation irradiation amount increases, an increase in modulus and adhesion of the first coating layer 420 may be controlled.

According to an embodiment, the second coating layer 430 may be disposed below the glass 410 (e.g., on the rear surface 410b). The second coating layer 430 may include a first portion 431 disposed below the first area S1 of the glass 410 and a second portion 432 disposed below the second area S2 of the glass 410. The first portion 431 of the second coating layer 430 may include a 1-1th portion 431a and a 1-2th portion 431b, wherein the 1-1th portion 431a may correspond to the 1-1th area S11 of the glass 410, and the 1-2th portion 431b may correspond to the 1-2th area S12 of the glass 410. The second portion 432 of the second coating layer 430 may correspond to a bending or rolling area of the flexible display (e.g., the second portion S2 of the glass 410). For example, the second portion 432 of the second coating layer 430 may be a portion of or a structure corresponding to a folding area of the flexible display (e.g., the folding area 233 of FIG. 4).

According to an embodiment, the second coating layer 430 may be a structure whose shape varies along a long length direction (e.g., Y-axis direction). The first portion 431 and the second portion 432 of the second coating layer 430 may have different shapes. For example, a thickness of the first portion 431 and a thickness of the second portion 432 may be different.

According to an embodiment, at least a portion of the second portion 432 of the second coating layer 430 may have a shape bent in a direction opposite to the glass 410 (e.g., -Z-axis direction). For example, a front surface (e.g., a side facing the +Z axis) of the second portion 432 may be formed to be concave with respect to a front surface (e.g., a side facing the +Z axis) of the first portion 431 (e.g., the 1-1th portion 431a and the 1-2th portion 431b). For example, the front surface of the second portion 432 may form a curved surface bent in the -Z-axis direction compared to the front surface of the first portion 431 (e.g., the 1-1th portion 431a and the 1-2th portion 431b). For example, in case of being viewed toward the front surface of the second coating layer 430, the second portion 432 of the second coating layer 430 may have a shape recessed in a direction opposite to the glass 410 with respect to the first portion 431. A rear surface (e.g., a side facing the -Z axis) of the second portion 432 may extend to form a flat surface with a rear surface (e.g., a side facing the -Z axis) of the first portion 431 (e.g., the 1-1th portion 431a and the 1-2th portion 431b).

According to an embodiment, the first portion 431 of the second coating layer 430 may have an overall uniform thickness (e.g., the same thickness). For example, a thickness of the 1-1th portion 431a and a thickness of the 1-2th portion 431b may be substantially the same. The first portion 431 of the second coating layer 430 may maintain a plane that does not bend or roll because it is a portion of or a structure corresponding to a flat area of the flexible display (e.g., the first display area 231 and the second display area 332 of FIG. 4).

According to an embodiment, a thickness of the second portion 432 of the second coating layer 430 may be substantially different from a thickness of the first portion 431. For example, the thickness of the second portion 432 of the second coating layer 430 may be smaller than the thickness of the first portion 431.

According to an embodiment, the second portion 432 of the second coating layer 430 may be provided in a shape corresponding to the second area S2 of the glass 410. For example, in case that a front surface of the second portion 432 of the second coating layer 430 has a concave (or recessed) shape, at least a portion of the second area S2 of the glass 410 may be a structure filling the concave shape.

Referring to the cross-section of FIG. 6, the second portion 432 of the second coating layer 430 may have a symmetrical shape with respect to a folding axis (e.g., line C-C' of FIG. 5). A value (e.g., an absolute value) of a slope (e.g., a slope of a tangent line) of a front surface of the second portion 432 of the second coating layer 430 may gradually (or sequentially) increase away from the folding axis (e.g., line C-C' of FIG. 5). For example, the value of the slope (e.g., the slope of the tangent line) of the front surface of the second portion 432 may increase toward an area adjacent to the 1-1th portion 431a based on the folding axis (e.g., line C-C' of FIG. 5). For example, the value of the slope (e.g., the slope of the tangent line) of the front surface of the second portion 432 may increase toward an area adjacent to the 1-2th portion 431b based on the folding axis (e.g., line C-C' of FIG. 5).

According to an embodiment, as the rear surface of the second coating layer 430 forms an overall flat surface, a thickness of the second portion 432 may gradually (or sequentially) increase away from the folding axis (e.g., line C-C' of FIG. 5). For example, the thickness of the second portion 432 may increase toward an area adjacent to the 1-1th portion 431a based on the folding axis (e.g., line C-C' of FIG. 5). For example, the thickness of the second portion 432 may increase toward an area adjacent to the 1-2th portion 421b based on the folding axis (e.g., line C-C' of FIG. 5).

According to an embodiment, the second coating layer 430 may be a film layer composed of a transparent polymer. The second coating layer 430 may include an optically clear resin (OCR) filler. The OCR filler may have substantially the same refractive index as the glass 410 (e.g., a refractive index of 0.05R or more). The OCR filler may be an elastic material including an adhesive component. For example, the OCR filler may be natural rubber, styrene butadiene rubber, styreneisoprene-styrene (co)polymer, styrene-butadiene-styrene (co)polymer, (meth)acrylic (co)polymer, polyacrylate, polyolefin, polyisobutylene and polyisoprene, polyurethane, polyvinyl ethyl ether, polysiloxane, silicone, polyurea, or a mixture of at least one thereof.

According to an embodiment, the second coating layer 430 may be a material including an adhesive component. The second coating layer 430 may include at least one of optical clear adhesive (OCA), pressure sensitive adhesive (PSA), thermal reactive adhesive, ultraviolet adhesive, general adhesive, or double-sided tape.

According to an embodiment, the second coating layer 430 may have a smaller modulus than the first coating layer 420. For example, the modulus of the second coating layer 430 may be about 8 MPa to 12 MPa. For example, the modulus of the second coating layer 430 may be about 10 MPa. According to an embodiment, an additive (e.g., a crosslinking agent, a curing agent), heat, and/or light (e.g., ultraviolet, radiation) irradiation amount may be adjusted to control a modulus property value of the second coating layer 430. By adjusting the corresponding factor (e.g., additive, heat, and/or light), an average molecular weight (Mn) or a degree of polymerization of the second coating layer 430 may be controlled, and thus, a property value desired by an operator may be obtained. For example, as the amount of the additive increases or as the heat/ultraviolet/radiation irradiation amount increases, an increase in modulus and adhesion of the second coating layer 430 may be controlled.

FIG. 8 is a view for comparing a repulsive moment and stress difference between a flexible cover structure according to an embodiment of the disclosure and a general flexible cover structure (e.g., comparative experimental examples).

The configurations of the cover structures of (a), (b), (c), and (d) of FIG. 8 represent cross-sections of a bending section corresponding to a folding area of a flexible display (e.g., the folding area 233 of the flexible display 230 of FIG. 4).

(e) of FIG. 8 illustrates a cross-section of a folded state of a flexible cover structure according to an embodiment, and (f) of FIG. 8 illustrates a cross-section of a folded state of a general flexible cover structure. According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400 formed such that at least a portion thereof is exposed to the outside to protect the flexible display panel.

The cover structure 400 of (a), (e) of FIG. 8 may include a glass 410, a first coating layer 420 disposed on a front surface of the glass 410, and a second coating layer 430 disposed on a rear surface of the glass 410, and a bending section A2 may provide a bent shape. The first coating layer 420 of the cover structure 400 of (a) of FIG. 8 may be named as OCR1, and the second coating layer 430 may be named as OCR2.

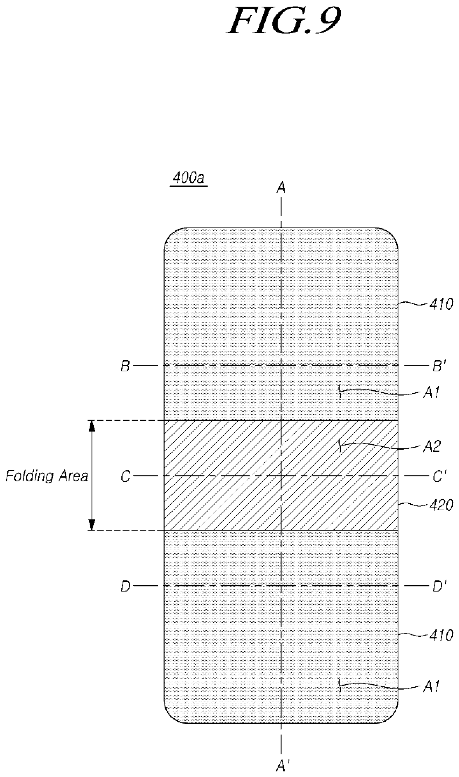

The configuration of the flexible cover structure 400 of (a), (e) of FIG. 8 may be identical in portion or in whole to the configuration of the display 230 of FIGS. 2A to 4 and the flexible cover structure 400 of FIGS. 4 to 6C. The embodiment of (a), (e) of FIG. 8 may be partially combined with the embodiments of FIGS. 1 to 7C or the embodiments of FIGS. 9 to 36.

In a general foldable electronic device, two films are stacked and used on a glass facing a front surface of a display panel. One film (e.g., a protective layer (PL)) is adhered onto the glass to provide a role of protecting the display panel and the glass, and the other film is disposed on the PL to provide a role of further maximizing a protection effect.

According to an embodiment of the disclosure, the cover structure 400 of the flexible display 230 may be provided as a structure in which the first coating layer 420 (e.g., OCR1) is filled in the glass 410 to primarily protect the glass, rather than a structure in which a film is attached onto the glass, or may be provided as a structure in which only one detachable protective film is attached on the first coating layer 420. According to an embodiment, the first coating layer 420 (e.g., OCR1), which is relatively thicker than the flat section in the bending section of the cover structure 400, provides impact resistance performance, and thus, the structure of the first coating layer 420 filled on the glass 410, or a stacked structure of only the glass 410, the first coating layer 420, and one protective film may also secure enhanced impact resistance performance. Further, according to an embodiment, the cover structure 400 may reduce a repulsive force due to folding of the display and increase a touch feeling of the glass 410 due to the first coating layer (e.g., OCR1) thinner than the general PL film.

According to an embodiment of the disclosure, the effect of reducing the repulsive force and crease (e.g., wrinkles at a folding portion) may be identified through finite element analysis. For the analysis, experimental examples (configurations of the cover structures 41, 42, 43 of (b), (c), (d) of FIG. 8) for comparison with the flexible cover structure 400 of (a) of FIG. 8 are illustrated. (b) of FIG. 8 may be named as a Comparative 1 structure, (c) of FIG. 8 may be named as a Comparative 2 structure, and (d) of FIG. 8 may be named as a Comparative 3 structure.

The cover structures 41, 42, 43 of (b), (c), (d) of FIG. 8 may include glass 41a, 42a, 43a, first coating layers 41b, 42b, 43b disposed on front surfaces of the glass 41a, 42a, 43a, and second coating layers 41c, 42c, 43c disposed on rear surfaces of the glass 41a, 42a, 43a, and bending sections do not have a bent shape, and a thickness of at least a portion of each layer may be different compared to the cover structure 400 of (a) of FIG. 8. The first coating layers 41b, 42b of the cover structures 41, 42 of (b), (c) of FIG. 8 may be named as OCR1, and the second coating layers 41c, 42c may be named as OCR2. The first coating layer 43b of the cover structure 43 of (d) of FIG. 8 may be named as PET, and the second coating layer 43c may be named as OCA.

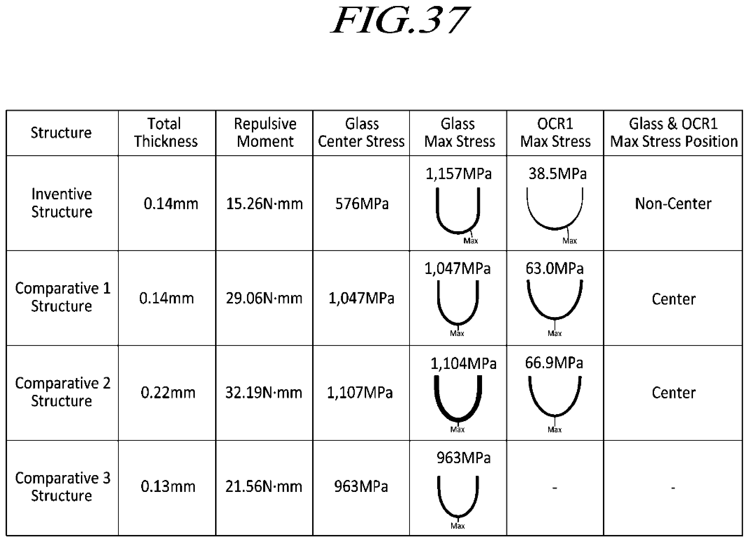

For comparison between an embodiment of the disclosure and experimental examples, a modulus of OCR1 was unified to about 600 MPa and a modulus of OCR2 was unified to about 10 MPa, and a repulsive force difference was compared through a repulsive moment (N·mm) value generated when each stacked structure (e.g., the flexible cover structure 400 of (a) of FIG. 8 and the cover structures 41, 42, 43 of (b), (c), (d) of FIG. 8) was folded to a radius of about 1.5 mm. The comparison content may be identified with reference to FIG. 37 below. Further, referring to FIG. 37, a degree of crease may be estimated through a value and position of Max Stress (MPa) applied to the glass 410, 41a, 42a, 43a and OCR1.

Referring to FIG. 37, it may be identified that a repulsive moment value of an inventive structure according to an embodiment (e.g., the flexible cover structure 400) is smaller compared to experimental examples (e.g., Comparative 1 structure, Comparative 2 structure, Comparative 3 structure). For example, it may be identified that a repulsive moment according to an embodiment is enhanced by about 47% compared to a repulsive moment of the Comparative 1 structure coated with OCR1 and OCR2 of the same thickness as in the embodiment of the disclosure. (e.g., 29.06 N·mm -> 15.26 N·mm, -47%).

Referring to FIG. 37, the inventive structure according to an embodiment (e.g., the flexible cover structure 400) may distribute stress applied to the glass 410 and each coating layer (e.g., the first coating layer 420, the second coating layer 430) during folding to reduce stress generated at a folding center, and move a position where Max Stress occurs to an outer edge away from the folding center. Further, the inventive structure according to an embodiment (e.g., the flexible cover structure 400) may reduce a magnitude of Max Stress applied to OCR1 by about 39% during folding. (e.g., 63.0 MPa -> 38.5 MPa)

Accordingly, the flexible cover structure 400 according to an embodiment, in which OCR1 is formed to be filled in the forming section of the glass, may provide decreased crease compared to crease occurring when stress is concentrated at a folding center in case of using a cover structure 400 without the forming section or using a general material (e.g., PET, OCA, or PSA material).

Referring to (e) of FIG. 8 and (f) of FIG. 8, stress values may be compared in a folded state of the cover structures. (e) of FIG. 8 illustrates a folding cross-section of the cover structure 400 in which the first coating layer 420, the glass 410, and the second coating layer 430 are stacked, and (f) of FIG. 8 illustrates a folding cross-section of the cover structure 41 in which the first coating layer 41b, the glass 41a, and the second coating layer 41c are stacked.

In the case of the folding cross-section of (e) of FIG. 8, it may be identified that the first coating layer 420, the glass 410, and the second coating layer 430 are all folded at different curvatures, and in the case of the folding cross-section of (f) of FIG. 8, it may be identified that the first coating layer 41b, the glass 41a, and the second coating layer 41c are folded in a uniform concentric form. As in (e) of FIG. 8, an embodiment of the disclosure distributes stress applied to the glass 410 and each coating layer (e.g., the first coating layer 420, the second coating layer 430) to reduce stress generated at a folding center, and moves a position where Max Stress occurs to an outer edge away from the center, thereby reducing crease and repulsive force generated at the folding center.

FIG. 9 is a view illustrating a front surface of a flexible cover structure 400a in an unfolded state of an electronic device according to an embodiment of the disclosure.

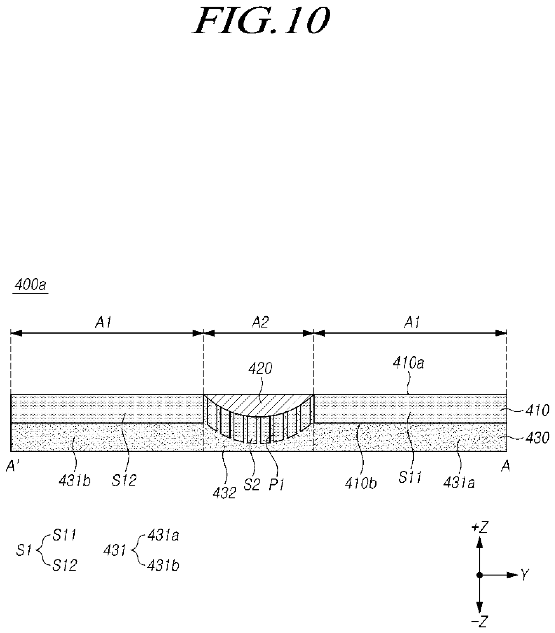

FIG. 10 is a cross-sectional view illustrating the flexible cover structure 400a taken along line A-A' of FIG. 9 according to an embodiment of the disclosure.

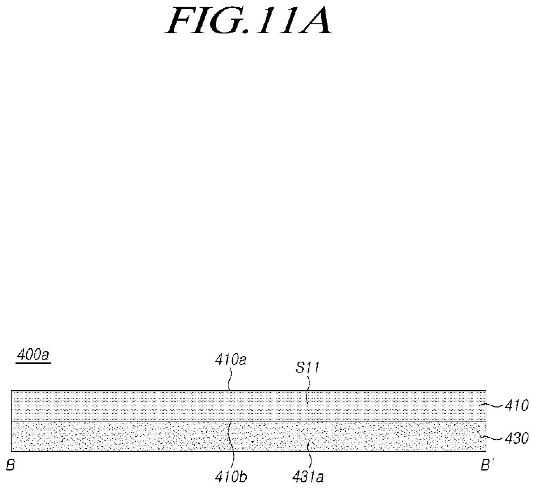

FIG. 11A is a cross-sectional view illustrating the flexible cover structure 400a taken along line B-B' of FIG. 9 according to an embodiment of the disclosure.

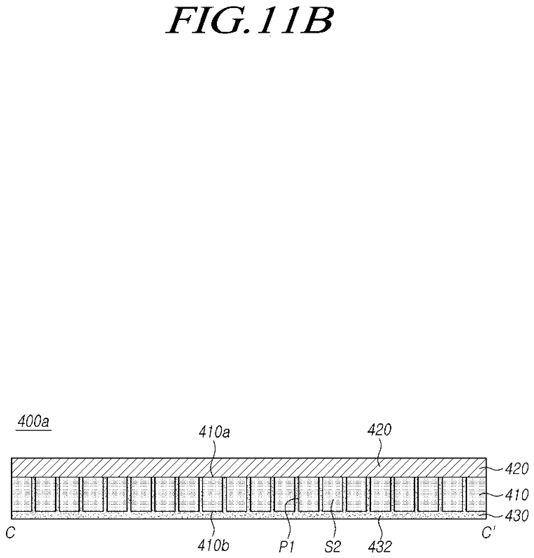

FIG. 11B is a cross-sectional view illustrating the flexible cover structure 400a taken along line C-C' of FIG. 9 according to an embodiment of the disclosure.

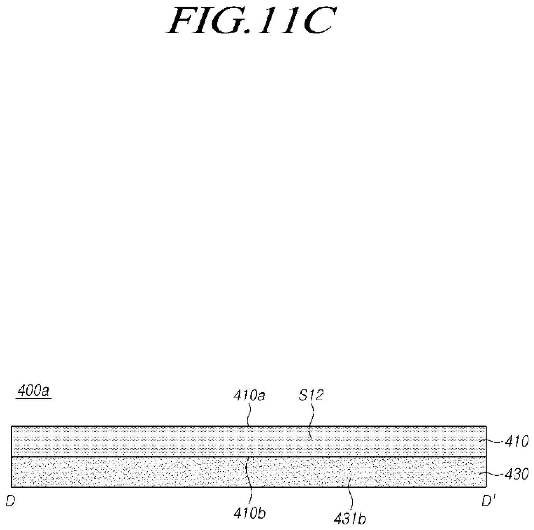

FIG. 11C is a cross-sectional view illustrating the flexible cover structure 400a taken along line D-D' of FIG. 9 according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400a formed such that at least a portion thereof is exposed to the outside to protect the flexible display panel.

According to an embodiment, the flexible cover structure 400a may be a flexible structure to correspond to operations of the unfolded state, the intermediate state, and the folded state of the flexible display 230. According to an embodiment, the flexible cover structure 400a of an electronic device (e.g., the electronic device 101 of FIGS. 1 to 3) may include a glass 410, a first coating layer 420 disposed on a portion (e.g., the second area S2) of the glass 410, and a second coating layer 430 disposed below the glass 410.

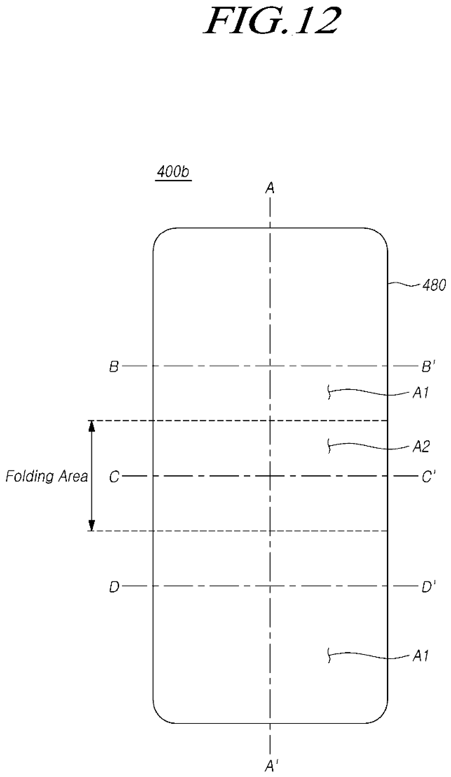

The configuration of the flexible cover structure 400a of FIGS. 9 to 11C may be identical in portion or in whole to the configuration of the display 230 of FIGS. 2A and 4. The embodiments of FIGS. 9 to 11C may be partially combined with the embodiments of FIGS. 1 to 8 and/or the embodiments of FIGS. 12 to 36.

According to an embodiment, the cover structure 400a may include a flat section A1 corresponding to a flat area of the flexible display panel and a bending section A2 corresponding to a bending or rolling area of the flexible display panel. The first coating layer 420, the glass 410, and the second coating layer 430 forming the bending section A2 of the cover structure 400a may vary according to a state of the electronic device 101 (e.g., from a flat state or an unfolded state to a folded state). A sum of thicknesses of the first coating layer 420, the glass 410, and the second coating layer 430 forming the bending section A2 of the cover structure 400a may be substantially equal to a sum of thicknesses of the glass 410 and the second coating layer 430 forming the flat section A1 of the cover structure 400a.

According to an embodiment, the glass 410 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween.

According to an embodiment, the glass 410 may include the first area S1 and the second area S2, and the first area S1 and the second area S2 may form an overall uniform thickness (e.g., the same thickness).

According to an embodiment, the second area S2 of the glass 410 may have a shape bent in a direction toward the second coating layer 430. For example, the front surface 410a (e.g., a side facing the +Z-axis direction) of the second area S2 may be formed to be concave with respect to the front surface of the first area S1 (e.g., the 1-1th area S11 and the 1-2th area S12), and the rear surface 410b (e.g., a side facing the -Z-axis direction) of the second area S2 may be formed to be convex with respect to the rear surface of the first area S1 (e.g., the 1-1th area S11 and the 1-2th area S12).

According to an embodiment, referring to the cross-section of FIG. 10, the second area S2 of the glass 410 may have a symmetrical shape with respect to a folding axis (e.g., line C-C' of FIG. 9). A value (e.g., an absolute value) of a slope (e.g., a slope of a tangent line) of the front surface 410a and/or the rear surface 410b of the second area S2 of the glass 410 may gradually (or sequentially) increase away from the folding axis (e.g., line C-C' of FIG. 9). For example, the value of the slope (e.g., the slope of the tangent line) of the front surface 410a and/or the rear surface 410b of the second area S2 may increase toward an area adjacent to the 1-1th area S11 based on the folding axis (e.g., line C-C' of FIG. 9). For example, the value of the slope (e.g., the slope of the tangent line) of the front surface 410a and/or the rear surface 410b of the second area S2 may increase toward an area adjacent to the 1-2th area S12 based on the folding axis (e.g., line C-C' of FIG. 9).

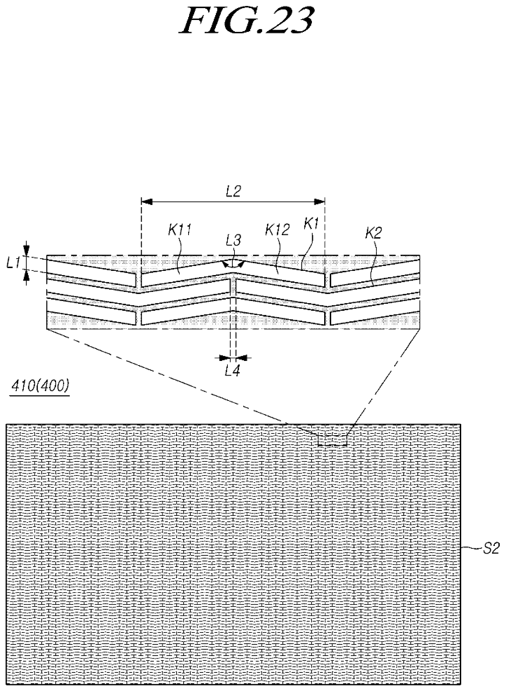

According to an embodiment, the second area S2 of the glass 410 may include a pattern. For example, the pattern may include a plurality of openings P1 penetrating from the front surface 410a of the glass 410 to the rear surface 410b. An arrangement of the plurality of openings P1 may form a regular pattern (e.g., refer to the pattern shape of FIG. 23). For example, a spacing and a diameter of the plurality of openings P1 may be disposed with a designated size.

According to an embodiment, the plurality of openings P1 formed in the second area S2 of the glass 410 may easily and stably receive a variable amount of the glass that flexibly extends during bending or rolling of the glass 410, thereby reducing repulsive force and stress.

According to an embodiment, a thickness of the second area S2 of the glass 410 may be substantially the same as a thickness of the first area S1. A thickness of the glass 410 may be about 70 µm or more as a whole. For example, the thickness of the glass 410 may be about 100 µm to 200 µm as a whole. The glass 410 of the flexible cover structure 400a of FIGS. 9 to 11C may be designed to have a greater thickness compared to the glass 410 of the flexible cover structure 400 of FIGS. 5 to 7C. In a process of filling the first coating layer 420 on the glass 410, the first coating layer 420 may be disposed within a shape (e.g., a concave shape) of the second area S2, and may be excluded from being disposed on the first area S1 or may be removed after being disposed on the first area S1. For example, the front surface 410a of the first area S1 of the glass 410 may be exposed to the outside. Accordingly, the cover structure 400a in which the first coating layer 420 is filled only in the second area S2 of the glass 410 may enhance a touch feeling felt by a user.

According to an embodiment, the first coating layer 420 may be disposed on a portion of the glass 410 (e.g., on the front surface 410a). The first coating layer 420 may be disposed on the second area S2 of the glass 410 and may not be disposed on the first area S1. The first coating layer 420 may correspond to a bending or rolling area of the flexible display.

According to an embodiment, the first coating layer 420 may have a shape bent in a direction toward the glass 410. For example, a rear surface (e.g., a side facing the -Z axis) of the first coating layer 420 may be formed to be convex with respect to the rear surface 410b of the first area S1 of the glass 410. For example, the rear surface of the first coating layer 420 may form a curved surface bent in the -Z-axis direction compared to the rear surface 410b of the first area S1 of the glass 410.

According to an embodiment, the first coating layer 420 may be provided in a shape corresponding to the second area S2 of the glass 410. For example, in case that the front surface 410a of the second area S2 of the glass 410 has a concave (or recessed) shape, the first coating layer 420 may be a structure filling the concave shape.

According to an embodiment, the second coating layer 430 may be disposed below the glass 410 (e.g., on the rear surface 410b). The second coating layer 430 may include a first portion 431 disposed on the first area S1 of the glass 410 and a second portion 432 disposed on the second area S2 of the glass 410. The first portion 431 of the second coating layer 430 may include a 1-1th portion 431a and a 1-2th portion 431b, wherein the 1-1th portion 431a may correspond to the 1-1th area S11 of the glass 410, and the 1-2th portion 431b may correspond to the 1-2th area S12 of the glass 410. The second portion 432 of the second coating layer 430 may correspond to a bending or rolling area of the flexible display (e.g., the second area S2 of the glass 410).

According to an embodiment, at least a portion of the second portion 432 of the second coating layer 430 may be provided in a shape corresponding to the second area S2 of the glass 410. For example, in case that the front surface 410a of the second portion 432 of the second coating layer 430 has a concave (or recessed) shape, at least a portion of the second area S2 of the glass 410 may be a structure filling the concave shape.

According to an embodiment, a portion of the second portion 432 of the second coating layer 430 may be provided in a shape corresponding to a pattern of the second area S2 of the glass 410. For example, a portion of the second portion 432 of the second coating layer 430 may have a shape filling the plurality of openings P1 of the glass 410. For example, a portion of the second portion 432 of the second coating layer 430 may be disposed within the plurality of openings P1, and a portion penetrating through the plurality of openings P1 may face (or contact) the first coating layer 420. The second coating layer 430, which is more flexible than the glass 410, may be filling the second area S2 of the glass 410 to facilitate bending or rolling of the display.

FIG. 12 is a view illustrating a front surface of a flexible cover structure 400b in an unfolded state of an electronic device according to an embodiment of the disclosure.

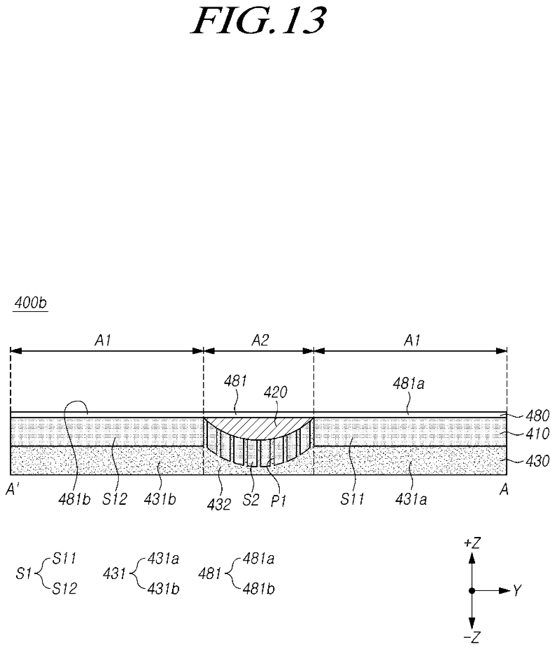

FIG. 13 is a cross-sectional view illustrating the flexible cover structure 400b taken along line A-A' of FIG. 12 according to an embodiment of the disclosure.

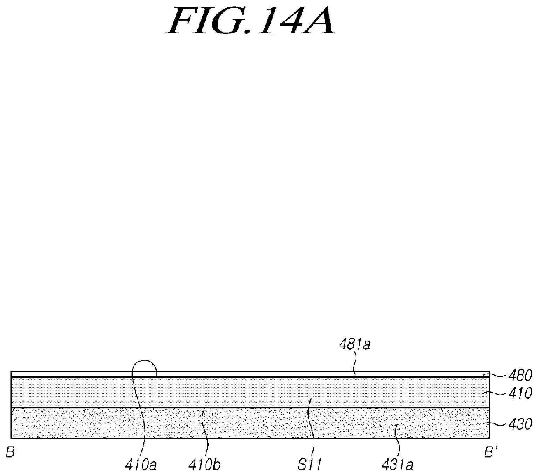

FIG. 14A is a cross-sectional view illustrating the flexible cover structure 400b taken along line B-B' of FIG. 12 according to an embodiment of the disclosure.

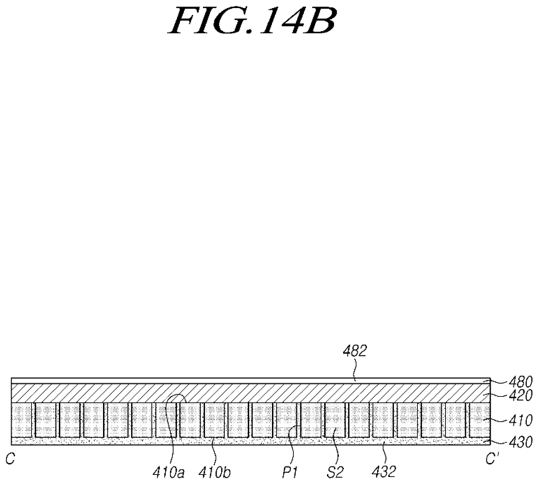

FIG. 14B is a cross-sectional view illustrating the flexible cover structure 400b taken along line C-C' of FIG. 12 according to an embodiment of the disclosure.

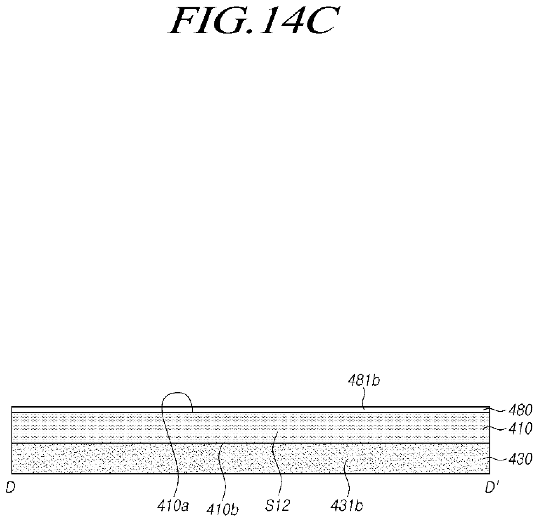

FIG. 14C is a cross-sectional view illustrating the flexible cover structure 400b taken along line D-D' of FIG. 12 according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400b formed such that at least a portion thereof is exposed to the outside to protect the flexible display panel.

According to an embodiment, the flexible cover structure 400b may be a flexible structure to correspond to operations of the unfolded state, the intermediate state, and the folded state of the flexible display 230.

According to an embodiment, the flexible cover structure 400b of an electronic device (e.g., the electronic device 101 of FIGS. 1 to 3) may include a glass 410, a first coating layer 420 disposed on a portion (e.g., the second area S2) of the glass 410, a second coating layer 430 disposed below the glass 410, and a protective layer 480 disposed on the first coating layer 420.

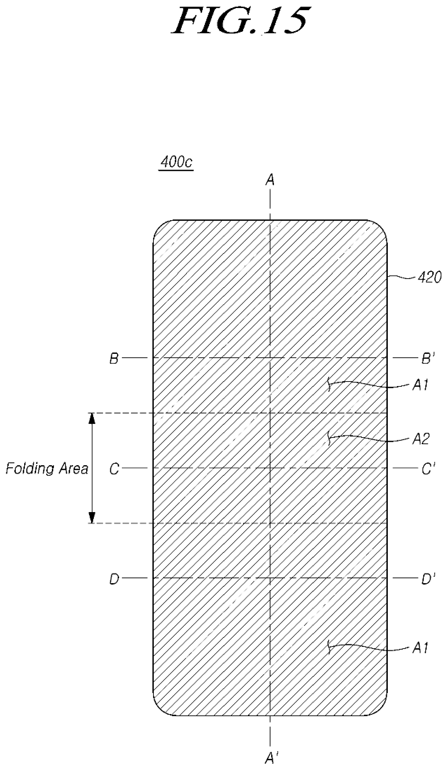

The configuration of the flexible cover structure 400b of FIGS. 12 to 14C may be identical in portion or in whole to the configuration of the display 230 of FIGS. 2A and 4 and/or the configuration of the flexible cover structure 400, 400a of FIGS. 5 to 11C. The embodiments of FIGS. 12 to 14C may be partially combined with the embodiments of FIGS. 1 to 11C or the embodiments of FIGS. 15 to 36.

According to an embodiment, the cover structure 400b may include a flat section A1 corresponding to a flat area of the flexible display panel and a bending section A2 corresponding to a bending or rolling area of the flexible display panel. The first coating layer 420, the glass 410, and the second coating layer 430 forming the bending section A2 of the cover structure 400b may vary according to a state of the electronic device 101 (e.g., from a flat state or an unfolded state to a folded state). A sum of thicknesses of the first coating layer 420, the glass 410, and the second coating layer 430 forming the bending section A2 of the cover structure 400b may be substantially equal to a sum of thicknesses of the glass 410 and the second coating layer 430 forming the flat section A1 of the cover structure 400b.

According to an embodiment, the glass 410 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween.

According to an embodiment, the glass 410 may include the first area S1 and the second area S2, and the first area S1 and the second area S2 may form an overall uniform thickness (e.g., the same thickness).

According to an embodiment, the second area S2 of the glass 410 may have a shape bent in a direction toward the second coating layer 430. For example, the front surface 410a (e.g., a side facing the +Z-axis direction) of the second area S2 may be formed to be concave with respect to the front surface of the first area S1 (e.g., the 1-1th area S11 and the 1-2th area S12), and the rear surface 410b (e.g., a side facing the -Z-axis direction) of the second area S2 may be formed to be convex with respect to the rear surface of the first area S1 (e.g., the 1-1th area S11 and the 1-2th area S12).

According to an embodiment, referring to the cross-section of FIG. 13, the second area S2 of the glass 410 may have a symmetrical shape with respect to a folding axis (e.g., line C-C' of FIG. 12). A value (e.g., an absolute value) of a slope (e.g., a slope of a tangent line) of the front surface 410a and/or the rear surface 410b of the second area S2 of the glass 410 may gradually (or sequentially) increase away from the folding axis (e.g., line C-C' of FIG. 12). For example, the value of the slope (e.g., the slope of the tangent line) of the front surface 410a and/or the rear surface 410b of the second area S2 may increase toward an area adjacent to the 1-1th area S11 based on the folding axis (e.g., line C-C' of FIG. 12). For example, the value of the slope (e.g., the slope of the tangent line) of the front surface 410a and/or the rear surface 410b of the second area S2 may increase toward an area adjacent to the 1-2th area S12 based on the folding axis (e.g., line C-C' of FIG. 12).

According to an embodiment, the second area S2 of the glass 410 may include a pattern. For example, the pattern may include a plurality of openings P1 penetrating from the front surface 410a of the glass 410 to the rear surface 410b. An arrangement of the plurality of openings P1 may form a regular pattern (e.g., refer to the pattern shape of FIG. 23). For example, a spacing and a diameter of the plurality of openings P1 may be disposed with a designated size.

According to an embodiment, the plurality of openings P1 formed in the second area S2 of the glass 410 may easily and stably receive a variable amount of the glass that flexibly extends during bending or rolling of the glass 410, thereby reducing repulsive force and stress.

According to an embodiment, a thickness of the second area S2 of the glass 410 may be substantially the same as a thickness of the first area S1. A thickness of the glass 410 may be about 70 µm or more as a whole. For example, the thickness of the glass 410 may be about 100 µm to 200 µm as a whole. The glass 410 of the flexible cover structure 400b of FIGS. 12 to 14C may be designed to have a greater thickness compared to the glass 410 of the flexible cover structure 400 of FIGS. 5 to 7C. In a process of filling the first coating layer 420 on the glass 410, the first coating layer 420 may be disposed within a shape (e.g., a concave shape) of the second area S2, and may be excluded from being disposed on the first area S1 or may be removed after being disposed on the first area S1. For example, the front surface 410a of the first area S1 of the glass 410 may be exposed to the outside. Accordingly, the cover structure 400b in which the first coating layer 420 is filled only in the second area S2 of the glass 410 may enhance a touch feeling felt by a user.

According to an embodiment, the first coating layer 420 may be disposed on a portion of the glass 410 (e.g., on the front surface 410a). The first coating layer 420 may be disposed on the second area S2 of the glass 410 and may not be disposed on the first area S1. The first coating layer 420 may correspond to a bending or rolling area of the flexible display.

According to an embodiment, the first coating layer 420 may have a shape bent in a direction toward the glass 410. For example, a rear surface (e.g., a side facing the -Z axis) of the first coating layer 420 may be formed to be convex with respect to the rear surface 410b of the first area S1 of the glass 410. For example, the rear surface of the first coating layer 420 may form a curved surface bent in the -Z-axis direction compared to the rear surface 410b of the first area S1 of the glass 410.

According to an embodiment, the first coating layer 420 may be provided in a shape corresponding to the second area S2 of the glass 410. For example, in case that the front surface 410a of the second area S2 of the glass 410 has a concave (or recessed) shape, the first coating layer 420 may be a structure filling the concave shape.

According to an embodiment, the second coating layer 430 may be disposed below the glass 410 (e.g., on the rear surface 410b). The second coating layer 430 may include a first portion 431 disposed on the first area S1 of the glass 410 and a second portion 432 disposed on the second area S2 of the glass 410. The first portion 431 of the second coating layer 430 may include a 1-1th portion 431a and a 1-2th portion 431b, wherein the 1-1th portion 431a may correspond to the 1-1th area S11 of the glass 410, and the 1-2th portion 431b may correspond to the 1-2th area S12 of the glass 410. The second portion 432 of the second coating layer 430 may correspond to a bending or rolling area of the flexible display (e.g., the second area S2 of the glass 410).

According to an embodiment, at least a portion of the second portion 432 of the second coating layer 430 may be provided in a shape corresponding to the second area S2 of the glass 410. For example, in case that the front surface 410a of the second portion 432 of the second coating layer 430 has a concave (or recessed) shape, at least a portion of the second area S2 of the glass 410 may be a structure filling the concave shape.

According to an embodiment, a portion of the second portion 432 of the second coating layer 430 may be provided in a shape corresponding to a pattern of the second area S2 of the glass 410. For example, a portion of the second portion 432 of the second coating layer 430 may have a shape filling the plurality of openings P1 of the glass 410. For example, a portion of the second portion 432 of the second coating layer 430 may be disposed within the plurality of openings P1, and a portion penetrating through the plurality of openings P1 may face (or contact) the first coating layer 420. The second coating layer 430, which is more flexible than the glass 410, may be filling the second area S2 of the glass 410 to facilitate bending or rolling of the display.

According to an embodiment, the protective layer 480 may be disposed on the glass 410 and/or on the first coating layer 420. The protective layer 480 may include a first film portion 481 disposed on the first coating layer 420 and a second film portion 482 disposed on the second area S2 of the glass 410. The first film portion 481 of the protective layer 480 may include a 1-1th film portion 481a and a 1-2th film portion 481b, wherein the 1-1th film portion 481a may correspond to the 1-1th area S11 of the glass 410, and the 1-2th film portion 812 may correspond to the 1-2th area S12 of the glass 410. The second film portion 482 of the protective layer 480 may correspond to the first coating layer 420 and may correspond to a bending or rolling area of the flexible display. For example, the second film portion 782 of the protective layer 480 may be a portion of or a structure corresponding to a folding area of the flexible display (e.g., the folding area 233 of FIG. 4).

According to an embodiment, the front surface of the first area S1 of the glass 410 and the front surface of the first coating layer 420 filled on the second area S2 of the glass 410 may form a flat surface, and the protective layer 480 may be disposed thereon with the same thickness. For example, the first film portion 481 and the second film portion 482 of the protective layer 480 may have an overall uniform thickness (e.g., the same thickness). A thickness of the protective layer 480 may be smaller than thicknesses of the glass 410 and the first coating layer 420.

According to an embodiment, a sum of thicknesses of the protective layer 480, the first coating layer 420, the glass 410, and the second coating layer 430 forming the bending section A2 of the cover structure 400b may be substantially equal to a sum of thicknesses of the protective layer 480, the glass 410, and the second coating layer 430 forming the flat section A1 of the cover structure 400b.

According to an embodiment, the protective layer 480 may form an outermost layer of the cover structure 400b and may resolve a foreign feeling (e.g., a catching feeling) occurring at a boundary surface between the front surface of the glass 410 and the first coating layer 420. The protective layer 480 may be a detachable layer. The protective layer 480 may have a thickness of about 5 µm to 10 µm.

According to an embodiment, the protective layer 480 may be composed of at least one layer and may be a layer for surface denting, scratch, slip property, or fingerprint resistance performance. For example, the protective layer 480 may be a composite film of PET and/or OCA as a film material. For example, the protective layer 480 may include at least one of an anti-fouling layer or an anti-fingerprint layer (AF layer), a hard coating layer (HC layer), an anti-reflection layer (AR layer) or a low reflection layer (LR layer), or an anti-glare layer (AG layer).

FIG. 15 is a view illustrating a front surface of a flexible cover structure 400c in an unfolded state of an electronic device according to an embodiment of the disclosure.

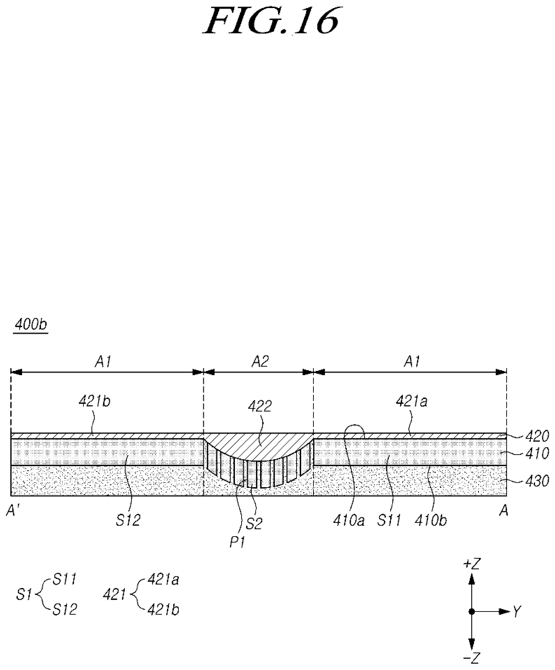

FIG. 16 is a cross-sectional view illustrating the flexible cover structure 400c taken along line A-A' of FIG. 15 according to an embodiment of the disclosure.

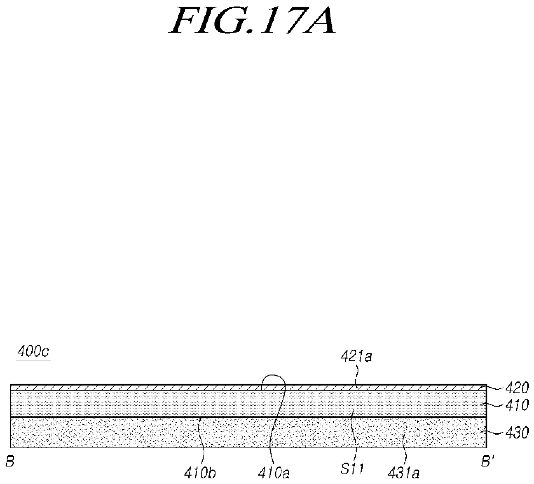

FIG. 17A is a cross-sectional view illustrating the flexible cover structure 400c taken along line B-B' of FIG. 15 according to an embodiment of the disclosure.

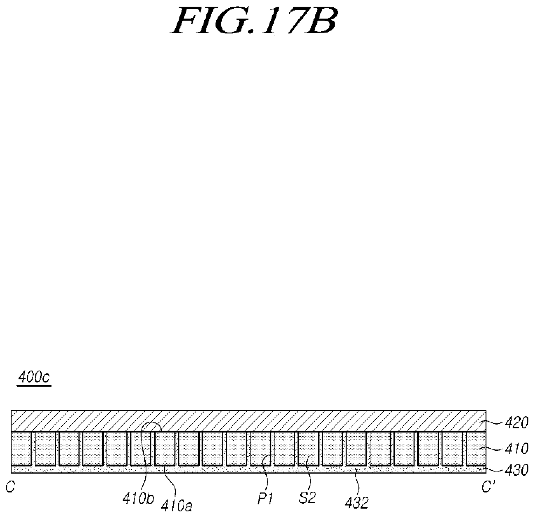

FIG. 17B is a cross-sectional view illustrating the flexible cover structure 400c taken along line C-C' of FIG. 15 according to an embodiment of the disclosure.

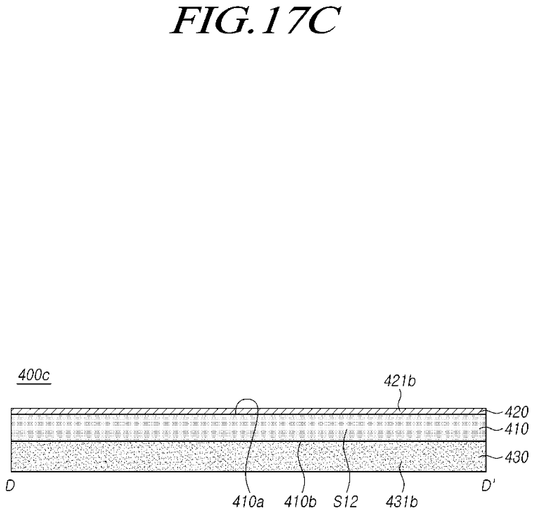

FIG. 17C is a cross-sectional view illustrating the flexible cover structure 400c taken along line D-D' of FIG. 15 according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400c formed such that at least a portion thereof is exposed to the outside to protect the flexible display panel.

According to an embodiment, the flexible cover structure 400c may be a flexible structure to correspond to operations of the unfolded state, the intermediate state, and the folded state of the flexible display 230.

According to an embodiment, the flexible cover structure 400c of an electronic device (e.g., the electronic device 101 of FIGS. 1 to 3) may include a glass 410, a first coating layer 420 disposed on the glass 410, and a second coating layer 430 disposed below the glass 410.

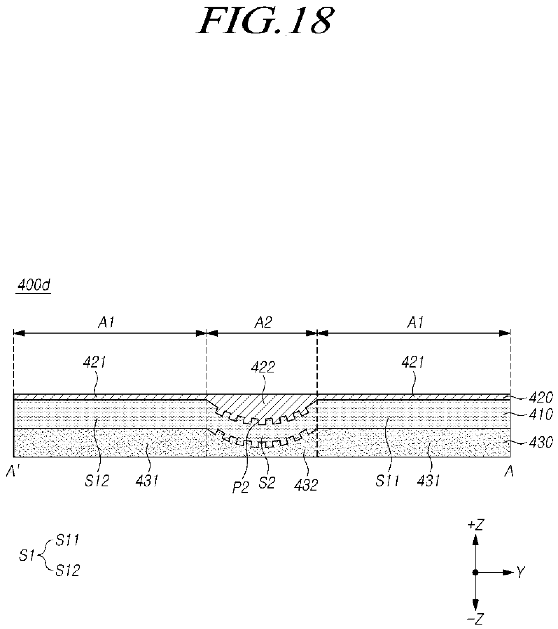

The configuration of the flexible cover structure 400c of FIGS. 15 to 17C may be identical in portion or in whole to the configuration of the display 230 of FIGS. 2A and 4 and/or the configuration of the flexible cover structure 400, 400a, 400b of FIGS. 5 to 14C. The embodiments of FIGS. 15 to 17C may be partially combined with the embodiments of FIGS. 1 to 14C or the embodiments of FIGS. 18 to 36.

According to an embodiment, the cover structure 400c may include a flat section A1 corresponding to a flat area of the flexible display panel and a bending section A2 corresponding to a bending or rolling area of the flexible display panel. The first coating layer 420, the glass 410, and the second coating layer 430 forming the bending section A2 of the cover structure 400c may vary according to a state of the electronic device 101 (e.g., from a flat state or an unfolded state to a folded state). A sum of thicknesses of the first coating layer 420, the glass 410, and the second coating layer 430 forming the bending section A2 of the cover structure 400c may be substantially equal to a sum of thicknesses of the first coating layer 420, the glass 410, and the second coating layer 430 forming the flat section A1 of the cover structure 400c.

According to an embodiment, the glass 410 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween.

According to an embodiment, the glass 410 may include the first area S1 and the second area S2, and the first area S1 and the second area S2 may form an overall uniform thickness (e.g., the same thickness).

According to an embodiment, the second area S2 of the glass 410 may have a shape bent in a direction toward the second coating layer 430. For example, the front surface 410a of the second area S2 may be formed to be concave with respect to the front surface 410a of the first area S1 (e.g., the 1-1th area S11 and the 1-2th area S12), and the rear surface 410b of the second area S2 may be formed to be convex with respect to the rear surface 410b of the first area S1 (e.g., the 1-1th area S11 and the 1-2th area S12).

According to an embodiment, referring to the cross-section of FIG. 16, the second area S2 of the glass 410 may have a symmetrical shape with respect to a folding axis (e.g., line C-C' of FIG. 15). A value (e.g., an absolute value) of a slope (e.g., a slope of a tangent line) of the front surface 410a and/or the rear surface 410b of the second area S2 of the glass 410 may gradually (or sequentially) increase away from the folding axis (e.g., line C-C' of FIG. 15). For example, the value of the slope (e.g., the slope of the tangent line) of the front surface 410a and/or the rear surface 410b of the second area S2 may increase toward an area adjacent to the 1-1th area S11 based on the folding axis (e.g., line C-C' of FIG. 15). For example, the value of the slope (e.g., the slope of the tangent line) of the front surface 410a and/or the rear surface 410b of the second area S2 may increase toward an area adjacent to the 1-2th area S12 based on the folding axis (e.g., line C-C' of FIG. 15).

According to an embodiment, the second area S2 of the glass 410 may include a pattern. For example, the pattern may include a plurality of openings P1 penetrating from the front surface 410a of the glass 410 to the rear surface 410b. An arrangement of the plurality of openings P1 may form a regular pattern (e.g., refer to the pattern shape of FIG. 23). For example, a spacing and a diameter of the plurality of openings P1 may be disposed with a designated size.

According to an embodiment, the first coating layer 420 may be disposed on the glass 410 (e.g., on the front surface 410a). The first coating layer 420 may include a first portion 421 disposed on the first area S1 of the glass 410 and a second portion 422 disposed on the second area S2 of the glass 410. The first portion 421 of the first coating layer 420 may include a 1-1th portion 421a and a 1-2th portion 421b, wherein the 1-1th portion 421a may correspond to the 1-1th area S11 of the glass 410, and the 1-2th portion 421b may correspond to the 1-2th area S12 of the glass 410. The second portion 422 of the first coating layer 420 may correspond to a bending or rolling area of the flexible display (e.g., the second area S2 of the glass 410).

According to an embodiment, at least a portion of the second portion 422 of the first coating layer 420 may have a shape bent in a direction toward the glass 410. For example, a rear surface (e.g., a side facing the -Z axis) of the second portion 422 may be formed to be convex with respect to a rear surface (e.g., a side facing the -Z axis) of the first portion 421 (e.g., the 1-1th portion 421a and the 1-2th portion 421b). For example, the rear surface of the second portion 422 may form a curved surface bent in the -Z-axis direction compared to the rear surface of the first portion 421 (e.g., the 1-1th portion 421a and the 1-2th portion 421b). For example, in case of being viewed toward the rear surface of the first coating layer 420, the second portion 422 of the first coating layer 420 may have a shape protruding in a direction of the glass 410 with respect to the first portion 421. A front surface (e.g., a side facing the +Z axis) of the second portion 422 may extend to form a flat surface with a front surface (e.g., a side facing the +Z axis) of the first portion 421 (e.g., the 1-1th portion 421a and the 1-2th portion 421b).

According to an embodiment, the first portion 421 of the first coating layer 420 may have an overall uniform thickness (e.g., the same thickness). For example, a thickness of the 1-1th portion 421a and a thickness of the 1-2th portion 421b may be substantially the same. The first portion 421 of the first coating layer 420 may maintain a plane that does not bend or roll because it is a portion of or a structure corresponding to a flat area of the flexible display (e.g., the first display area 231 and the second display area 332 of FIG. 4).

According to an embodiment, the second portion 422 of the first coating layer 420 may be provided in a shape corresponding to the second area S2 of the glass 410. For example, in case that the front surface 410a of the second area S2 of the glass 410 has a concave (or recessed) shape, the second portion 422 of the first coating layer 420 may be a structure filling the concave shape.

According to an embodiment, the second coating layer 430 may be disposed below the glass 410 (e.g., on the rear surface 410b). The second coating layer 430 may include a first portion 431 disposed below the first area S1 of the glass 410 and a second portion 432 disposed below the second area S2 of the glass 410. The first portion 431 of the second coating layer 430 may include a 1-1th portion 431a and a 1-2th portion 431b, wherein the 1-1th portion 431a may correspond to the 1-1th area S11 of the glass 410, and the 1-2th portion 431b may correspond to the 1-2th area S12 of the glass 410. The second portion 432 of the second coating layer 430 may correspond to a bending or rolling area of the flexible display (e.g., the second portion S2 of the glass 410).

According to an embodiment, the second portion 432 of the second coating layer 430 may be provided in a shape corresponding to the second area S2 of the glass 410. For example, in case that a front surface of the second portion 432 of the second coating layer 430 has a concave (or recessed) shape, at least a portion of the second area S2 of the glass 410 may be a structure filling the concave shape.

According to an embodiment, a portion of the second portion 432 of the second coating layer 430 may be provided in a shape corresponding to a pattern of the second area S2 of the glass 410. For example, a portion of the second portion 432 of the second coating layer 430 may have a shape filling the plurality of openings P1 of the glass 410. For example, a portion of the second portion 432 of the second coating layer 430 may be disposed within the plurality of openings P1, and a portion penetrating through the plurality of openings P1 may face (or contact) the first coating layer 420. The second coating layer 430, which is more flexible than the glass 410, may be filling the second area S2 of the glass 410 to facilitate bending or rolling of the display.

FIG. 18 is a cross-sectional view illustrating a flexible cover structure 400d taken along line A-A' of FIG. 5 according to an embodiment of the disclosure.

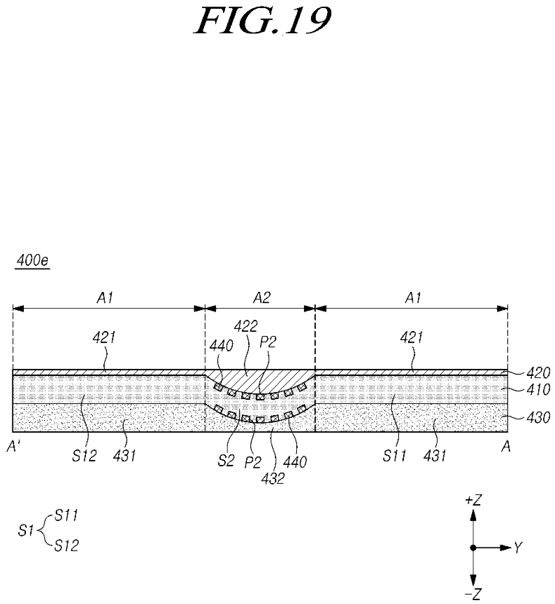

FIG. 19 is a cross-sectional view illustrating a flexible cover structure 400e taken along line A-A' of FIG. 5 according to an embodiment of the disclosure.

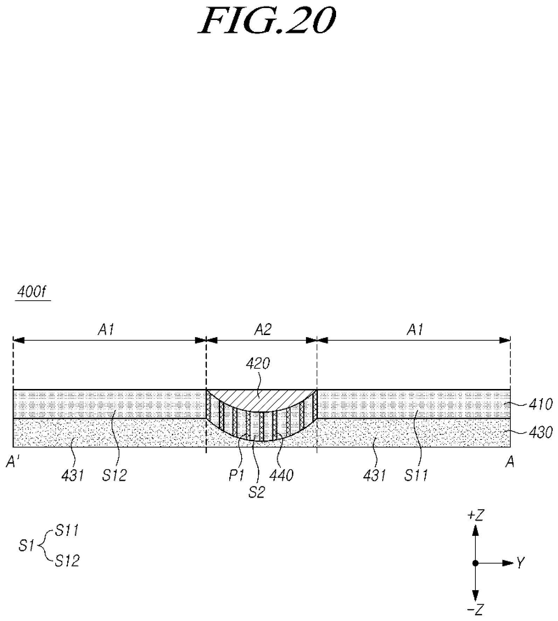

FIG. 20 is a cross-sectional view illustrating a flexible cover structure 400f taken along line A-A' of FIG. 9 according to an embodiment of the disclosure.

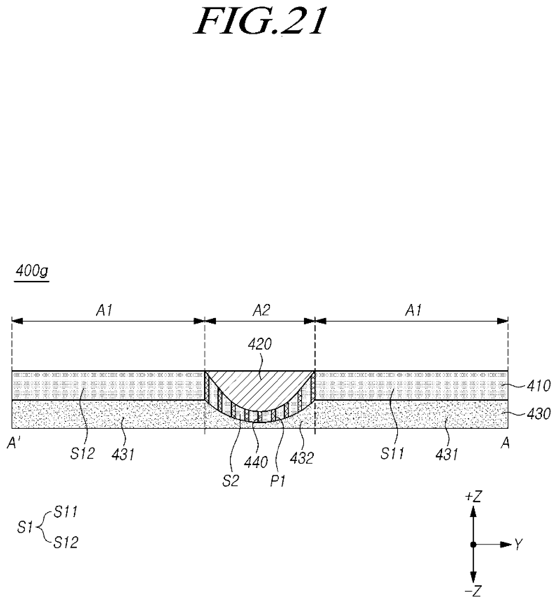

FIG. 21 is a cross-sectional view illustrating a flexible cover structure 400g taken along line A-A' of FIG. 9 according to an embodiment of the disclosure.

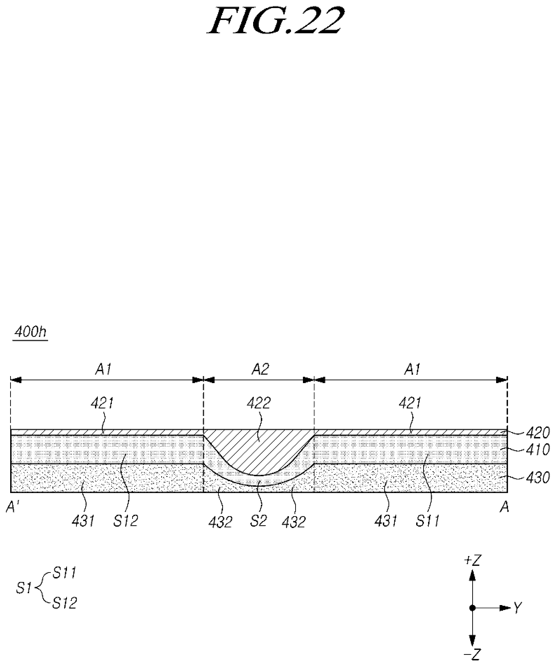

FIG. 22 is a cross-sectional view illustrating a flexible cover structure 400h taken along line A-A' of FIG. 5 according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure 400d, 400e, 400f, 400g, 400h formed such that at least a portion thereof is exposed to the outside to protect the flexible display panel.

According to an embodiment, the flexible cover structure 400c may be a flexible structure to correspond to operations of the unfolded state, the intermediate state, and the folded state of the flexible display 230.

The configuration of the flexible cover structure 400d, 400e, 400f, 400g, 400h of FIGS. 18 to 22 may be identical in portion or in whole to the configuration of the display 230 of FIGS. 2A and 4 and/or the configuration of the flexible cover structure 400, 400a, 400b, 400c of FIGS. 5 to 17C. The embodiments of FIGS. 18 to 22 may be partially combined with the embodiments of FIGS. 1 to 17C or the embodiments of FIGS. 23 to 36. Hereinafter, different components (e.g., the bending section A2 of the cover structure 400d, 400e, 400f, 400g, 400h) are mainly described.

According to an embodiment, the flexible cover structure 400d, 400e of an electronic device (e.g., the electronic device 101 of FIGS. 1 to 3) may include a glass 410, a first coating layer 420 disposed on the glass 410, and a second coating layer 430 disposed below the glass 410.

According to an embodiment, the glass 410 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween.

According to an embodiment, the second area S2 of the glass 410 may have a shape bent in a direction toward the second coating layer 430. For example, a front surface (e.g., a side facing the +Z-axis direction) of the second area S2 may be formed to be concave with respect to a front surface (e.g., a side facing the +Z-axis direction) of the first area S1, and a rear surface (e.g., a side facing the -Z-axis direction) of the second area S2 may be formed to be convex with respect to a rear surface (e.g., a side facing the +Z-axis direction) of the first area S1.

Referring to FIGS. 18 and 19 according to an embodiment, the second area S2 of the glass 410 may include a pattern. For example, the pattern may be a structure formed on a front surface of the glass 410 and may include recesses P2 disposed at regular intervals. The pattern may be a structure formed on a rear surface of the glass 410 and may include recesses P2 disposed at regular intervals. According to an embodiment, the recesses P2 formed on the front surface and the rear surface of the glass 410 may have shapes corresponding to each other. For example, the recesses P2 on the front surface and the recesses P2 on the rear surface may be disposed at regular intervals parallel to a bent shape in a shape facing each other.

Referring to FIGS. 18 and 19 according to an embodiment, the first coating layer 420 may be disposed on the glass 410. The first coating layer 420 may include a first portion 421 disposed on the first area S1 of the glass 410 and a second portion 422 disposed on the second area S2 of the glass 410. According to an embodiment, the second coating layer 430 may be disposed below the glass 410. The second coating layer 430 may include a first portion 431 disposed on the first area S1 of the glass 410 and a second portion 432 disposed on the second area S2 of the glass 410.

Referring to FIG. 18 according to an embodiment, the second portion 422 of the first coating layer 420 may be positioned along a curved shape to correspond to the second area S2 of the glass 410, and a portion thereof may be positioned (e.g., filled) within the recesses P2 disposed (or formed) on the front surface of the curved shape. According to an embodiment, the second portion 432 of the second coating layer 430 may be positioned along a curved shape to correspond to the second area S2 of the glass 410, and a portion thereof may be positioned (e.g., filled) within the recesses P2 disposed (or formed) on the rear surface of the curved shape.

Referring to FIG. 19 according to an embodiment, the flexible cover structure 400e may further include a third coating layer 440 positioned on one surface of the second area S2 (e.g., a bending area) of the glass 410. According to an embodiment, the second portion 422 of the first coating layer 420 may be disposed along a curved shape to correspond to the second area S2 of the glass 410, and the third coating layer 440 may be positioned (e.g., filled) within the recesses P2 disposed (or formed) on the front surface of the curved shape. According to an embodiment, the second portion 432 of the second coating layer 430 may be positioned along a curved shape to correspond to the second area S2 of the glass 410, and the third coating layer 440 may be positioned (e.g., filled) within the recesses P2 disposed (or formed) on the rear surface of the curved shape.

Referring to FIG. 19 according to an embodiment, the third coating layer 440 may be a film layer composed of a transparent polymer. The third coating layer 440 may include an optically clear resin (OCR) filler. The OCR filler may have substantially the same refractive index as the glass 410 (e.g., a refractive index of 0.05R or more). The OCR filler may be an elastic material including an adhesive component. For example, the OCR filler may be natural rubber, styrene butadiene rubber, styrene-isoprene-styrene (co)polymer, styrene-butadiene-styrene (co)polymer, (meth)acrylic (co)polymer, polyacrylate, polyolefin, polyisobutylene and polyisoprene, polyurethane, polyvinyl ethyl ether, polysiloxane, silicone, polyurea, or a mixture of at least one thereof.

Referring to FIG. 19 according to an embodiment, the third coating layer 440 may have a smaller modulus than the first coating layer 420 and the second coating layer 430. The low modulus of the third coating layer 440 may further reduce a repulsive force when the flexible display 230 is folded.

The cover structure 400d, 400e according to an embodiment of the disclosure may provide the recesses P2 of the glass 410 formed in the bending section A2 and corresponding shapes of the first coating layer 420, the second coating layer 430, and/or the third coating layer 440. Accordingly, the first coating layer 420 and the second coating layer 430 and/or the third coating layer 440, which are more flexible than the glass 410, may facilitate bending of the second area S2 of the glass 410.

According to an embodiment, the configuration of the flexible cover structure 400f of FIG. 20 may substantially apply the embodiment of FIGS. 9 to 11C.

Referring to FIG. 20 according to an embodiment, the second area S2 of the glass 410 may include a pattern. For example, the pattern may include a plurality of openings P1 penetrating from a front surface to a rear surface of the glass 410. An arrangement of the plurality of openings P1 may form a regular pattern (e.g., refer to the pattern shape of FIG. 23). For example, a spacing and a diameter of the plurality of openings P1 may be disposed with a designated size.

Referring to FIG. 20 according to an embodiment, the first coating layer 420 may be disposed on a portion of the glass 410. The first coating layer 420 may be disposed on the second area S2 of the glass 410 and may not be disposed on the first area S1. The first coating layer 420 may correspond to a bending or rolling area of the flexible display. According to an embodiment, the second coating layer 430 may be disposed below the glass 410.

Referring to FIG. 20 according to an embodiment, the flexible cover structure 400f may further include a third coating layer 440 positioned within the second area S2 (e.g., a bending area) of the glass 410. The third coating layer 440 may be positioned along a curved shape to correspond to the second area S2 of the glass 410, and at least a portion of the third coating layer 440 may be positioned (e.g., filled) within the plurality of openings P1 disposed (or formed) in the curved shape.

Referring to FIG. 20 according to an embodiment, the third coating layer 440 may be disposed between the first coating layer 420 and the second coating layer 430. The third coating layer 440 and the glass 410 may form a substantially uniform thickness (e.g., the same thickness).

The cover structure 400f according to an embodiment of the disclosure may provide the plurality of openings P1 formed in the second area S2 of the glass 410 and the third coating layer 440 filled in the plurality of openings P1. The third coating layer 440 may easily and stably receive a variable amount of the glass that flexibly extends during bending of the cover structure (e.g., the glass 410), thereby reducing repulsive force and stress.

According to an embodiment, the configuration of the flexible cover structure 400g of FIG. 21 may substantially apply the embodiments of FIGS. 9 to 11C and the embodiment of FIG. 20, and the configuration of the flexible cover structure 400h of FIG. 22 may substantially apply the embodiment of FIGS. 5 to 7C.

Referring to FIGS. 21 and 22 according to an embodiment, the glass 410 may include a first area S1 and a second area S2, and the first area S1 and the second area S2 may form overall different thicknesses. For example, a thickness of the second area S2 may be substantially smaller than a thickness of the first area S1.

Referring to FIGS. 21 and 22 according to an embodiment, the first area S1 of the glass 410 may have an overall uniform thickness (e.g., the same thickness). The second area S2 of the glass 410 may be formed to have a thickness that varies along a length direction (e.g., Y-axis direction). For example, a thickness of the second area S2 of the glass 410 may gradually (sequentially) decrease away from an area adjacent to the first area S1.

Referring to FIGS. 21 and 22 according to an embodiment, the second area S2 of the glass 410 may have a shape bent in a direction toward the second coating layer 430. For example, a front surface (e.g., a side facing the +Z axis) of the second area S2 may be formed to be concave with respect to a front surface of the first area S1, and a rear surface (e.g., a side facing the -Z axis) of the second area S2 may be formed to be convex with respect to the rear surface 410b of the first area S1.

Referring to FIGS. 21 and 22 according to an embodiment, the second area S2 of the glass 410 may have a symmetrical shape with respect to a folding axis (e.g., line C-C' of FIG. 5 and/or FIG. 9). A value (e.g., an absolute value) of a slope (e.g., a slope of a tangent line) of a front surface and/or a rear surface of the second area S2 of the glass 410 may gradually (or sequentially) increase away from the folding axis (e.g., line C-C' of FIG. 5 and/or FIG. 9). A thickness of the second area S2 of the glass 410 may form a smallest thickness in an area of the folding axis (e.g., line C-C' of FIG. 5 and/or FIG. 9) and may gradually (or sequentially) increase away from the folding axis (e.g., line C-C' of FIG. 5 and/or FIG. 9).

Referring to FIGS. 21 and 22 according to an embodiment, at least a portion of the first coating layer 420 or the second portion 422 of the first coating layer 420 may have a shape bent in a direction toward the glass 410. For example, a rear surface of the first coating layer 420 may be filled to correspond to a front surface of the glass 410 and may have a thickness that gradually (or sequentially) increases toward the folding axis (e.g., line C-C' of FIG. 5).

Referring to FIGS. 21 and 22 according to an embodiment, at least a portion of the second portion 432 of the second coating layer 430 may have a shape bent in a direction opposite to the glass 410 (e.g., -Z-axis direction). For example, a front surface of the second coating layer 430 may have a concave shape to correspond to a rear surface of the glass 410 and may have a thickness that gradually (or sequentially) decreases toward the folding axis (e.g., line C-C' of FIG. 5 and/or FIG. 9).

Referring to FIG. 22 according to an embodiment, shapes of the plurality of openings P1 of the glass 410 may have a length (e.g., thickness) that sequentially (or gradually) decreases as they correspond to the shape of the glass 410.

According to an embodiment, the third coating layer 440 may be positioned along a curved shape to correspond to the second area S2 of the glass 410, and at least a portion of the third coating layer 440 may be positioned (e.g., filled) within the plurality of openings P1 disposed (or formed) in the curved shape. The third coating layer 440 may be disposed between the first coating layer 420 and the second coating layer 430. The third coating layer 440 may have a length (e.g., thickness) that sequentially (or gradually) decreases as it corresponds to the shape of the glass 410.

The embodiments of FIGS. 21 and 22 may provide an additional repulsive force reduction effect compared to other embodiments as the glass 410 sequentially (or gradually) decreases toward the center (e.g., toward the folding axis (e.g., line C-C' of FIG. 5 and/or FIG. 9)) in the bending section A2 of the cover structure 400. The embodiments of FIGS. 21 and 22 may be structures applicable to a relatively thick glass compared to other embodiments. For example, the glass 410 of the embodiments of FIGS. 21 and 22 may have a greater thickness than the glass 410 of the embodiment of FIGS. 4 to 7C and the embodiment of FIGS. 15 to 17C. However, the shape of the glass 410 of the embodiments of FIGS. 21 and 22 is not limited to the illustrated structure and may be variously modified according to a design and structure of a foldable electronic device or stacking specifications.

FIG. 23 is a view illustrating a pattern of a glass of a flexible cover structure according to an embodiment of the disclosure.

According to an embodiment, an electronic device (e.g., the electronic device 101 of FIGS. 1 to 3) may include a first housing (e.g., the first housing 210 of FIGS. 2A and 3), a second housing (e.g., the second housing 220 of FIGS. 2A and 3), and a flexible display (e.g., the display 230 of FIGS. 2 and 4). The flexible display 230 may include a flexible display panel (e.g., the display panel 235 of FIG. 4) and a flexible cover structure formed such that at least a portion thereof is exposed to the outside to protect the flexible display panel.

According to an embodiment, the flexible cover structure 400 of an electronic device (e.g., the electronic device 101 of FIGS. 1 to 3) may include a glass 410 in which a pattern is formed. The glass 410 may include a first area (e.g., the first area S1 of FIGS. 5 to 7) and a second area (e.g., the second area S2 of FIGS. 8 to 7) extending from the first area S1 and corresponding to a bending or rolling area of the flexible display panel.

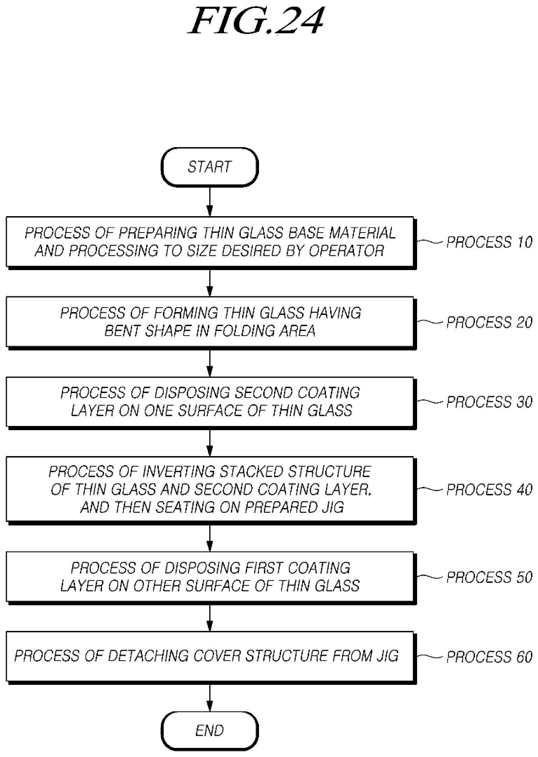

The configuration of the flexible cover structure 400 of FIG. 23 may be identical in portion or in whole to the configuration of the display 230 of FIGS. 2A and 4 and/or the configuration of the flexible cover structure 400, 400a, 400c, 400d, 400e, 400f, 400g, 400h of FIGS. 5 to 22. The embodiments of FIG. 23 may be partially combined with the embodiments of FIGS. 1 to 22 or the embodiments of FIGS. 24 to 36.

According to an embodiment, the second area S2 of the glass 410 may include a pattern. For example, the pattern may be at least one of a plurality of openings penetrating from a front surface to a rear surface of the glass 410, a plurality of recesses formed on a front surface and/or a rear surface of the glass 410, or a plurality of protruding portions.

According to an embodiment, factors determining the pattern of the glass 410 may be at least one of a pattern width L1, a pattern length L2, a pattern angle L3, and an inter-pattern distance L4. In a foldable electronic device, a pattern advantageous for the electronic device may be designed by controlling the factors considering at least one of a thickness of the flexible display panel, a thickness of the glass, and/or a folding radius.

Referring to an O area enlarged from a portion of the pattern of the glass 410, it may be identified that the pattern is disposed in a repeated arrangement of a first shape K1 and a second shape K2. The first shape K1 may be an inverted (e.g., 180-degree rotated) version of the second shape K2.

According to an embodiment, each of the first shape K1 and the second shape K2 may include a first slit K11 and a second slit K12 extending from the first slit K11, and the first slit K11 and the second slit K12 may be formed to have a designated pattern angle L3. The designated pattern angle L3 may form an obtuse angle, and a length and a thickness of the first slit K11 and the second slit K12 may be substantially the same.

According to an embodiment, the pattern of the glass 410 may be formed in a plurality of rows and columns (M x N), wherein odd columns may be an arrangement of a plurality of first shapes K1 and even columns may be an arrangement of a plurality of second shapes K2. For example, a first column may have an arrangement of a plurality of first shapes K1 and a second column may have an arrangement of a plurality of second shapes K2.

According to an embodiment, the arrangement of the first shapes K1 and the arrangement of the second shapes K2 may be disposed in a staggered manner so that they may be positioned as close to each other as possible. For example, in case of being viewed from a side of the glass 410, a portion of the first shape K1 and a portion of the second shape K2 may be disposed to overlap each other.

According to an embodiment, the pattern formed in the bending area of the glass 410 may easily and stably receive a variable amount of the glass that flexibly extends, thereby reducing repulsive force and stress occurring during display bending.

FIG. 24 is a flowchart illustrating a manufacturing process of a flexible cover structure according to an embodiment of the disclosure.

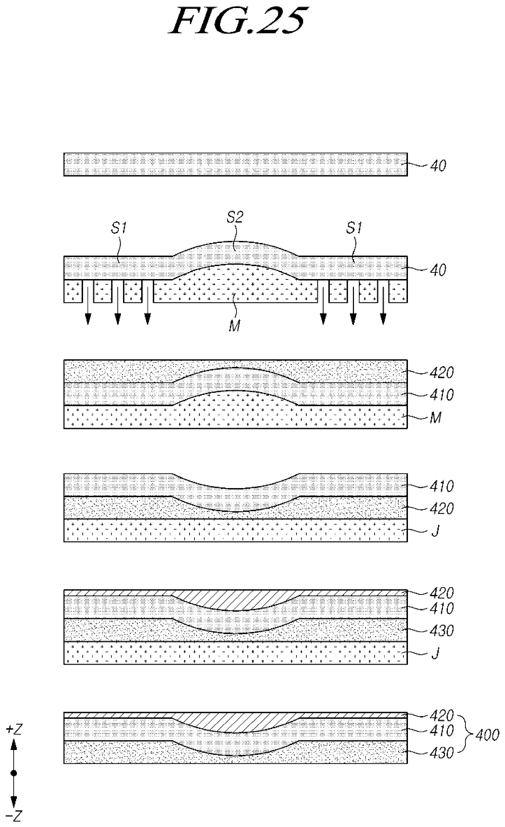

FIG. 25 is a view schematically illustrating a flow of a manufacturing process of a flexible cover structure according to an embodiment of the disclosure.

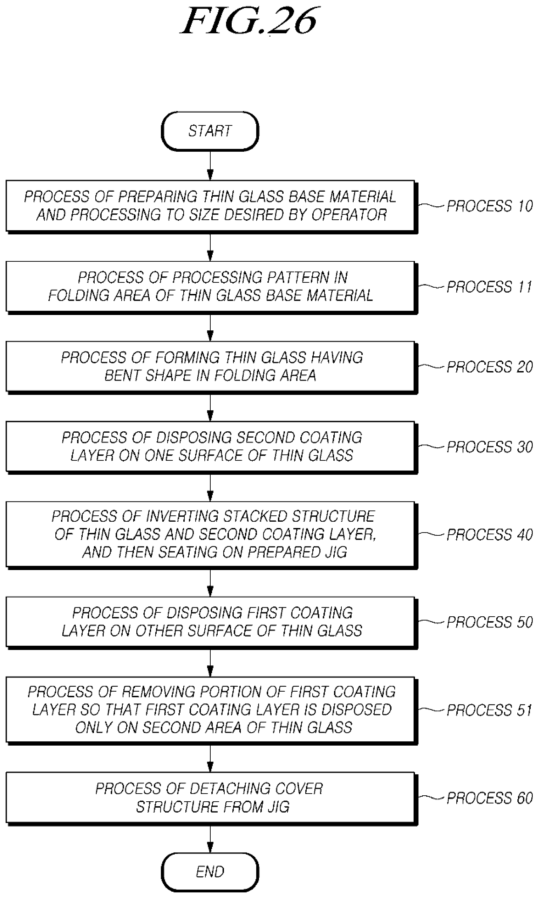

The configuration of the flexible cover structure 400 of FIGS. 24 and 25 may be identical in portion or in whole to the configuration of the display 230 of FIGS. 2A and 4 and/or the configuration of the flexible cover structure 400, 400a, 400c, 400d, 400e, 400f, 400g, 400h of FIGS. 5 to 22. The embodiment of FIGS. 24 and 25 may substantially apply the embodiment of FIGS. 5 to 7C. The embodiment of FIGS. 24 and 25 may be partially combined with the embodiments of FIGS. 4 to 23 and/or the embodiments of FIGS. 26 to 36.

According to an embodiment, the flexible cover structure 400 may include a glass 410, a first coating layer 420 disposed on the glass 410, and a second coating layer 430 disposed below the glass 410.

According to the manufacturing process of the flexible cover structure 400, first, a glass base material 40 may be prepared and then a process of processing to a size (or size) desired by an operator may be performed. (Process 10) For example, an operator may process an outer edge portion of the base material to prepare a glass base material 40 (e.g., a glass disk) to a desired size. A thickness of the processed glass base material 40 may be about 20 µm to 70 µm.

Thereafter, a process (e.g., a pre-treatment process) of forming a glass having a bent shape in a folding area (e.g., the second area S2) may be performed. (Process 20) A mold M includes a plurality of suction holes, and a central portion of the mold M may have a shape protruding (e.g., convex) in the +Z-axis direction to form a curved surface folding area. The second area S2 of the glass base material 40 seated on one surface of the mold M may vary to a temporarily bent form through suction at room temperature or a permanently bent form through high-temperature heat forming. The second area S2 of the glass 410 may have a shape bent (e.g., convex) in a direction toward the +Z axis.

Thereafter, a process of disposing the second coating layer 430 on one surface of the glass 410 may be performed. (Process 30) The second coating layer 430 may be filled on the glass 410, and a planarization process and a curing process may be performed. For example, as the second coating layer 430 is filled on the glass 410, a rear surface of the second coating layer 430 may have a shape bent (e.g., convex) in a direction toward the +Z axis to correspond to the shape of the second area S2 of the glass 410. A front surface of the second coating layer 430 may provide an overall uniform surface through a planarization process. As the second coating layer 430 finally forms a lower surface of the glass 410, a coating layer having a relatively low modulus compared to the first coating layer 420 described below may be used to reduce a repulsive force of the display.

Thereafter, a process of inverting (e.g., rotating 180 degrees) a stacked structure of the glass 410 and the second coating layer 430 so that a front surface/rear surface is inverted and then seating on a prepared jig J may be performed. (Process 40) For example, after inverting the stacked structure of the glass 410 and the second coating layer 430, the second area S2 of the glass 410 may expose a concave surface.

Thereafter, a process of disposing the first coating layer 420 on the other surface of the exposed glass 410 may be performed. (Process 50) The first coating layer 420 may be filled on the glass 410, and a planarization process and a curing process may be performed. For example, as the first coating layer 420 is filled on the glass 410, a rear surface of the first coating layer 420 may have a shape bent (e.g., concave) in a direction toward the -Z axis to correspond to the shape of the second area S2 of the glass 410. The first coating layer 420 may fill the concave portion of the thin glass 410, and a front surface of the first coating layer 420 may provide an overall uniform surface through a planarization process. As the first coating layer 420 finally forms a front surface of the glass 410, a coating layer having a relatively high modulus compared to the second coating layer 430 may be used to protect the display from an externally applied impact.

The first coating layer and the second coating layer 430 may be composed of a transparent polymer. The first coating layer and the second coating layer 430 may include an optically clear resin (OCR) filler. The OCR filler may be an elastic material including an adhesive component. For example, the OCR filler may be natural rubber, styrene butadiene rubber, styrene-isoprene-styrene (co)polymer, styrene-butadiene-styrene (co)polymer, (meth)acrylic (co)polymer, polyacrylate, polyolefin, polyisobutylene and polyisoprene, polyurethane, polyvinyl ethyl ether, polysiloxane, silicone, polyurea, or a mixture of at least one thereof.

Thereafter, a process of detaching a final cover structure 400 from the jig may be performed. (Process 60) The final cover structure 400 has a bent shape such that the second area S2 of the glass 410 corresponds to a bending or rolling area of the display panel, and a sum of thicknesses of the first coating layer 420, the glass 410, and the second coating layer 430 forming the bending section A2 of the cover structure 400 may be substantially equal to a sum of thicknesses of the first coating layer 420, the glass 410, and the second coating layer 430 forming the flat section A1 of the cover structure 400.

FIG. 26 is a flowchart illustrating a manufacturing process of a flexible cover structure according to an embodiment of the disclosure.

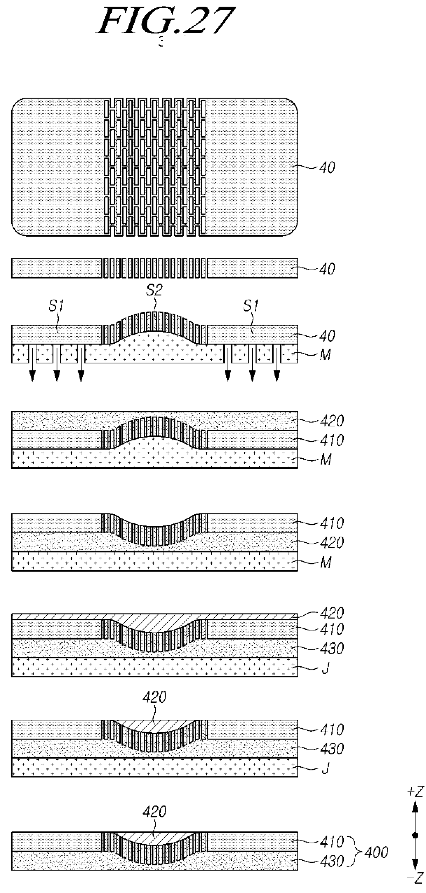

FIG. 27 is a view schematically illustrating a flow of a manufacturing process of a flexible cover structure according to an embodiment of the disclosure.

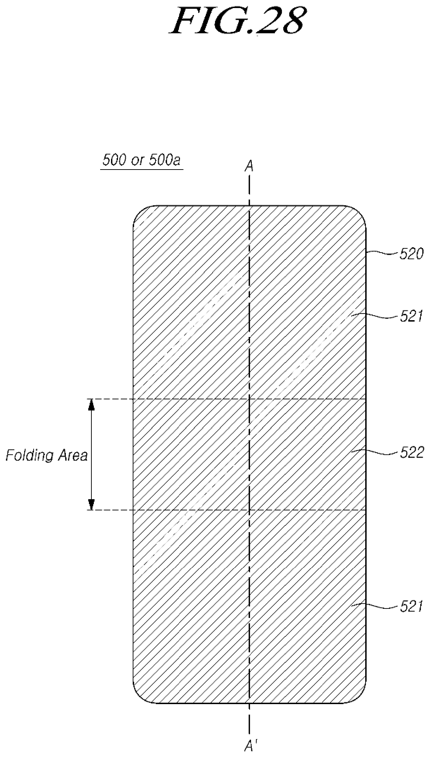

The configuration of the flexible cover structure 400 of FIGS. 26 and 27 may be identical in portion or in whole to the configuration of the display 230 of FIGS. 2A and 4 and/or the configuration of the flexible cover structure 400, 400a, 400c, 400d, 400e, 400f, 400g, 400h of FIGS. 5 to 22. The embodiment of FIGS. 26 and 27 may substantially apply the embodiment of FIGS. 9 to 11C. The embodiment of FIGS. 26 and 27 may be partially combined with the embodiments of FIGS. 4 to 25 and/or the embodiments of FIGS. 28 to 36.

According to an embodiment, the flexible cover structure 400 may include a glass 410, a first coating layer 420 disposed on the glass 410, and a second coating layer 430 disposed below the glass 410.

According to the manufacturing process of the flexible cover structure 400, first, a glass base material 40 may be prepared and then a process of processing a pattern to a size (or size) and a partial area (e.g., a folding area) desired by an operator may be performed. (Process 10, Process 11) For example, an operator may process an outer edge portion of the base material to prepare a glass base material 40 (e.g., a glass disk) to a desired size. A thickness of the processed glass base material 40 may be about 70 µm or more (e.g., 70 µm to 400 µm). An operator may process a designated pattern in a folding area (e.g., the second area S2) of the glass 410. The designated pattern may be at least one of a plurality of openings penetrating from a front surface to a rear surface of the glass 410, a plurality of recesses formed on a front surface and/or a rear surface of the glass 410, or a plurality of protruding portions.

If a thickness of the glass 410 according to an embodiment is 70 µm or more, a separate processing treatment (e.g., pattern processing) should be performed in the folding area to fold.

Thereafter, a process (e.g., a pre-treatment process) of forming a glass having a bent shape in a folding area (e.g., the second area S2) may be performed. (Process 20) A mold M includes a plurality of suction holes, and a central portion of the mold M may have a shape protruding (e.g., convex) in the +Z-axis direction to form a curved surface folding area. The second area S2 of the glass base material 40 seated on one surface of the mold M may vary to a temporarily bent form through suction at room temperature or a permanently bent form through high-temperature heat forming. The second area S2 of the glass 410 may have a shape bent (e.g., convex) in a direction toward the +Z axis.

Thereafter, a process of disposing the second coating layer 430 on one surface of the glass 410 may be performed. (Process 30) The second coating layer 430 may be filled on the glass 410 and inside the pattern, and a planarization process and a curing process may be performed. For example, as the second coating layer 430 is filled on the glass 410, a rear surface of the second coating layer 430 may have a shape bent (e.g., convex) in a direction toward the +Z axis to correspond to the shape of the second area S2 of the glass 410. The second coating layer 430, which is more flexible than the glass 410, may be filled in the pattern of the glass 410 to facilitate bending of the second area S2. A front surface of the second coating layer 430 may provide an overall uniform surface through a planarization process. As the second coating layer 430 finally forms a lower surface of the glass 410, a coating layer having a relatively low modulus compared to the first coating layer 420 described below may be used to reduce a repulsive force of the display.

Thereafter, a process of inverting (e.g., rotating 180 degrees) a stacked structure of the glass 410 and the second coating layer 430 so that a front surface/rear surface is inverted and then seating on a prepared jig J may be performed. (Process 40) For example, after inverting the stacked structure of the glass 410 and the second coating layer 430, the second area S2 of the glass 410 may expose a concave surface.

Thereafter, a process of disposing the first coating layer 420 on the other surface of the exposed glass 410 may be performed. (Process 50) The first coating layer 420 may be filled on the glass 410, and a planarization process and a curing process may be performed. For example, as the first coating layer 420 is filled on the glass 410, a rear surface of the first coating layer 420 may have a shape bent (e.g., concave) in a direction toward the -Z axis to correspond to the shape of the second area S2 of the glass 410. The first coating layer 420 may fill the concave portion of the glass 410, and a front surface of the first coating layer 420 may provide an overall uniform surface through a planarization process. As the first coating layer 420 finally forms a front surface of the glass 410, a coating layer having a relatively high modulus compared to the second coating layer 430 may be used to protect the display from an externally applied impact.

Thereafter, a process of removing a portion of the first coating layer 420 may be performed so that the first coating layer 420 is disposed only on the second area S2 of the glass 410. (Process 51) For example, by removing the first coating layer 420 filled on a front surface of the glass 410, the first area S1 of the glass 410 may be exposed to the outside, and the second area S2 may remain in a state in which the first coating layer 420 is filled. In case that a thickness of the glass 410 is 70 µm or more, since the glass has sufficient rigidity by itself, a surface of the glass may be exposed as an outermost surface for use. Further, because a user may directly touch the glass 410, an enhanced touch feeling may be provided.

Thereafter, a process of detaching a final cover structure 400 from the jig may be performed. (Process 60) The final cover structure 400 has a bent shape such that the second area S2 of the glass 410 corresponds to a bending or rolling area of the display panel, and a sum of thicknesses of the first coating layer 420, the glass 410, and the second coating layer 430 forming the bending section A2 of the cover structure 400 may be substantially equal to a sum of thicknesses of the first coating layer 420, the glass 410, and the second coating layer 430 forming the flat section A1 of the cover structure 400.

FIG. 28 is a view illustrating a front surface of a flexible cover structure 500, 500a in an unfolded state of an out-folding electronic device according to an embodiment of the disclosure.

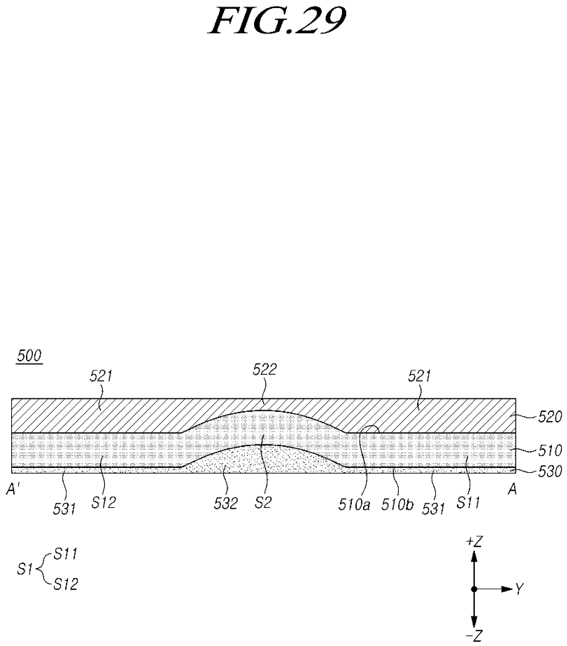

FIG. 29 is a cross-sectional view illustrating the flexible cover structure 500 taken along line A-A' of FIG. 28 according to an embodiment of the disclosure.

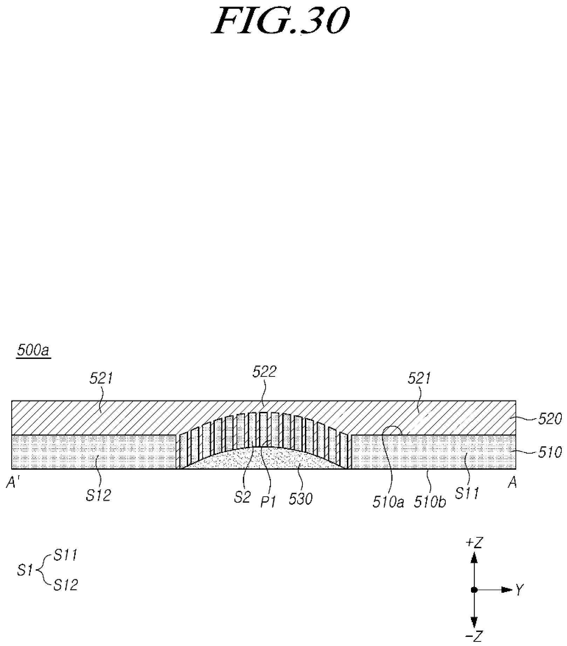

FIG. 30 is a cross-sectional view illustrating the flexible cover structure 500a taken along line A-A' of FIG. 28 according to an embodiment of the disclosure.

According to an embodiment, an electronic device (e.g., the electronic device 101 of FIG. 1) may include a first housing (e.g., the first housing 210 of FIG. 2), a second housing (e.g., the second housing 220 of FIG. 2), and a flexible display. The flexible display may include a flexible display panel and a flexible cover structure 500 formed such that at least a portion thereof is exposed to the outside to protect the flexible display panel.

According to an embodiment, according to a state of the electronic device 101 (e.g., from a flat state or an unfolded state to a folded state), the flexible display 230 may vary to an unfolded state, an intermediate state, or a folded state.

According to an embodiment, the electronic device 101 may be an out-folding device that folds in an outward direction. For example, the flexible display 230 may be provided to be always visible in the unfolded state, the intermediate state, and the folded state of the electronic device 101. The flexible display 230 may include a first flat area, a second flat area, and a folding area capable of bending or rolling between the first flat area and the second flat area. In an unfolded state of the electronic device 101, the first flat area, the folding area, and the second flat area may form the same plane. In a folded state of the electronic device 101, the first flat area and the second flat area may be parallel and disposed to face each other (e.g., toward opposite directions).

According to an embodiment, the flexible cover structure 500 may be a flexible structure to correspond to operations of the unfolded state, the intermediate state, and the folded state of the flexible display. For example, at least a portion of the flexible cover structure 500 may vary from an area forming a plane to an area forming bending or rolling when the electronic device operates in a folded state.

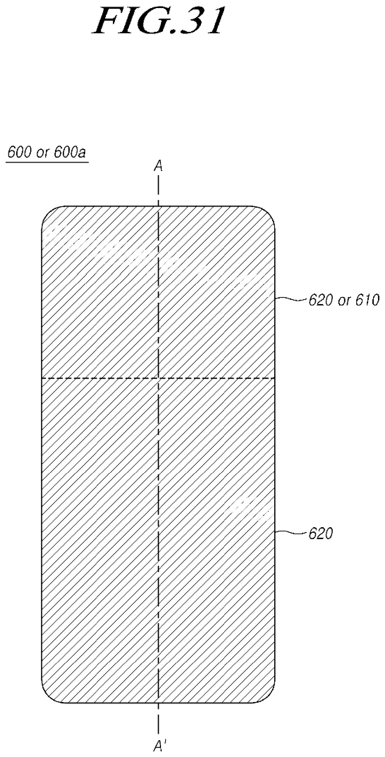

The configuration of the flexible cover structure 500, 500a of FIGS. 28 to 30 may be identical in portion or in whole to the configuration of the display 230 of FIGS. 2A and 4 and/or the configuration of the flexible cover structure 400, 400a, 400c, 400d, 400e, 400f, 400g, 400h of FIGS. 5 to 22. The embodiment of FIGS. 28 to 30 may be partially combined with the embodiments of FIGS. 4 to 27 and/or the embodiments of FIGS. 31 to 36.

According to an embodiment, the flexible cover structure 500, 500a may include a glass 510, a first coating layer 520 disposed on the glass 510, and a second coating layer 530 disposed below the glass 510.

According to an embodiment, the glass 510 may include a first area S1 and a second area S2 extending from the first area S1 and corresponding to a bending or rolling area of the flexible display panel. The first area S1 may include a 1-1th area S11 and a 1-2th area S12 spaced apart from each other with the second area S2 therebetween.

According to an embodiment, the glass 510 may include the first area S1 and the second area S2, and the first area S1 and the second area S2 may form an overall uniform thickness (e.g., the same thickness).

According to an embodiment, the second area S2 of the glass 510 may have a shape bent in a direction toward the first coating layer 520. For example, a front surface 510a of the second area S2 may be formed to be convex with respect to a front surface 510a of the first area S1 (e.g., the 1-1th area S11 and the 1-2th area S12), and a rear surface 510b of the second area S2 may be formed to be concave with respect to a rear surface 510b of the first area S1 (e.g., the 1-1th area S11 and the 1-2th area S12). For example, the front surface 510a of the second area S2 may form a curved surface bent in the +Z-axis direction compared to the front surface 510a of the first area S1 (e.g., the 1-1th area S11 and the 1-2th area S12), and the rear surface 510b of the second area S2 may form a curved surface bent in the +Z-axis direction compared to the rear surface 510b of the first area S1 (e.g., the 1-1th area S11 and the 1-2th area S12).

Referring to FIG. 29, the glass 510 may be formed without a pattern as a whole, and a thickness of the second area S2 of the glass 510 may be substantially the same as a thickness of the first area S1. A thickness of the glass 510 may be about 30 µm to 70 µm as a whole.

Referring to FIG. 30, the second area S2 of the glass 510 may form a pattern. The designated pattern may be at least one of a plurality of openings penetrating from a front surface to a rear surface of the glass 510, a plurality of recesses formed on a front surface and/or a rear surface of the glass 510, or a plurality of protruding portions. A thickness of the glass 510 may be about 70 µm or more (e.g., 70 µm to 400 µm) as a whole.

According to an embodiment, the first coating layer 520 may be disposed on the glass 510 (e.g., on the front surface 510a). The first coating layer 520 may include a first portion 521 disposed on the first area S1 of the glass 510 and a second portion 522 disposed on the second area S2 of the glass 510.

According to an embodiment, at least a portion of the second portion 522 of the first coating layer 520 may have a bent shape corresponding to the second area S2 of the glass 510. For example, a rear surface (e.g., a side facing the -Z axis) of the second portion 522 may be formed to be convex with respect to a rear surface (e.g., a side facing the -Z axis) of the first portion 521. For example, the rear surface of the second portion 522 may form a curved surface bent in the +Z-axis direction compared to the rear surface of the first portion 521. According to an embodiment, a front surface (e.g., a side facing the +Z axis) of the first portion 521 and the second portion 522 of the first coating layer 520 may form an overall flat surface.

Referring to FIG. 29, the second portion 522 of the first coating layer 520 may be positioned (e.g., filled) entirely along a front surface of the second area S2 of the glass 510.

Referring to FIG. 30, the second portion 522 of the first coating layer 520 may be positioned (e.g., filled) in a bent form along the second area S2 of the glass 510, and at least a portion thereof may provide a form filling a space of a shape of the pattern (e.g., the plurality of openings P1).

According to an embodiment, the second coating layer 530 may be disposed below the glass 510 (e.g., on the rear surface 510b). The second coating layer 530 may include a first portion 531 disposed on the first area S1 of the glass 510 and a second portion 532 disposed on the second area S2 of the glass 510.

According to an embodiment, at least a portion of the second coating layer 530 (or the second portion 532 of the second coating layer 530) may have a bent shape corresponding to the second area S2 of the glass 510. For example, a front surface (e.g., a side facing the +Z axis) of the second coating layer 530 (or the second portion 532 of the second coating layer 530) may be formed to be convex with respect to the rear surface 510b of the glass 510 (or a front surface (e.g., a side facing the -Z axis) of the first portion 521 of the second coating layer 530).

Referring to FIG. 29, a rear surface (e.g., a side facing the -Z axis) of the first portion 521 and the second portion 522 of the second coating layer 530 may form an overall flat surface.

Referring to FIG. 30, the second coating layer 530 may be disposed only on the second area S2 of the glass 510 and may be excluded from other areas.

FIGS. 29 and 30 illustrate a bent shape of the glass 510 and surrounding areas thereof, and the disclosure is not limited thereto and may be easily modified for a display cover structure favorable for bending considering a thickness change of the glass 510 and diversification of patterns.

According to an embodiment of FIGS. 28 to 30, a cover structure 500, 500a favorable for a display that is bent in an outward direction may be provided in an out-folding electronic device. The cover structure 500, 500a (e.g., the glass 510) may easily and stably receive a variable amount of the glass that flexibly extends during bending, thereby obtaining effects of resolving repulsive force and enhancing wrinkles (crease).

FIG. 31 is a view illustrating a front surface of a flexible cover structure 600, 600a in an unfolded state of a slidable electronic device according to an embodiment of the disclosure.

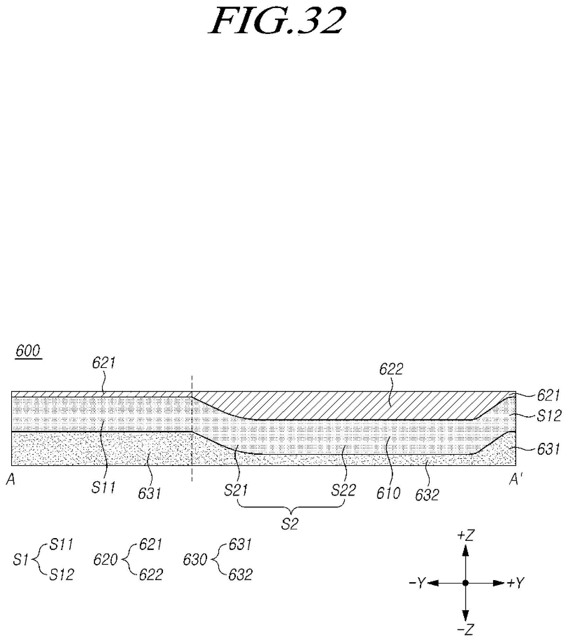

FIG. 32 is a cross-sectional view illustrating the flexible cover structure 600 taken along line A-A' of FIG. 31 according to an embodiment of the disclosure.

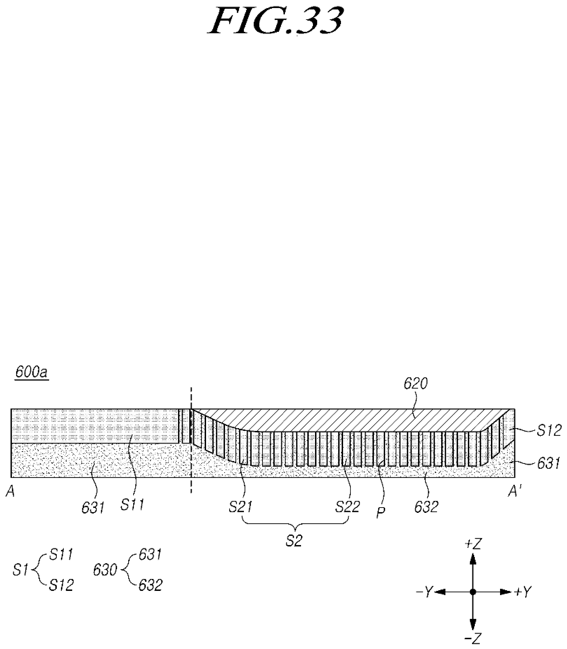

FIG. 33 is a cross-sectional view illustrating the flexible cover structure 600a taken along line A-A' of FIG. 31 according to an embodiment of the disclosure.

According to an embodiment, an electronic device (e.g., the electronic device 101 of FIG. 1) may include a first housing (e.g., the first housing 210 of FIG. 2), a second housing (e.g., the second housing 220 of FIG. 2), and a flexible display. The flexible display may include a flexible display panel and a flexible cover structure 600, 600a formed such that at least a portion thereof is exposed to the outside to protect the flexible display panel.

According to an embodiment, according to a state of the electronic device 101 (e.g., from a slide-in state to a slide-out state), the flexible display may vary to a slide-in state, an intermediate state, or a slide-out state.

According to an embodiment, as the flexible display varies from the slide-in state to the slide-out state, a visible area may be extended. For example, in the slide-in state of the electronic device 101, a partial area of the flexible display may be in a state positioned within a housing, and in the slide-out state of the electronic device 101, the partial area may be exposed to the outside or positioned to be visible.

According to an embodiment, the flexible cover structure 600, 600a may be a flexible structure corresponding to slide-in and slide-out operations of the flexible display. For example, at least a portion of the flexible cover structure 600, 600a may vary from an area forming a plane to an area forming bending (or rolling) during slide-in and slide-out operations of the electronic device 101, or an area forming bending (or rolling) may vary to an area forming a plane.

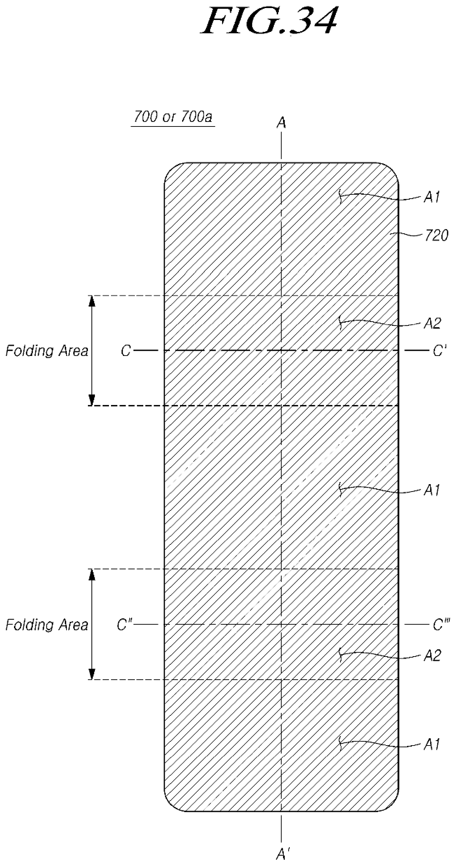

The configuration of the flexible cover structure 600, 600a of FIGS. 31 to 33 may be identical in portion or in whole to the configuration of the display 230 of FIGS. 2A and 4 and/or the configuration of the flexible cover structure 400, 400a, 400c, 400d, 400e, 400f, 400g, 400h, 500, 500a of FIGS. 5 to 30. The embodiment of FIGS. 31 to 33 may be partially combined with the embodiments of FIGS. 4 to 30 and the embodiments of FIGS. 34 to 36.

According to an embodiment, the flexible cover structure 600, 600a may include a glass 610, a first coating layer 620 disposed on the glass 610, and a second coating layer 630 disposed below the glass 610.

According to an embodiment, the glass 410 may include a first area S1 and a second area S2 extending from the first area S1 and corresponding to a bending or rolling area of the flexible display panel. The first area S1 and the second area S2 may form an overall uniform thickness (e.g., the same thickness).

According to an embodiment, a portion of the second area S2 of the glass 410 may have a shape bent (e.g., inclined) in a direction toward the second coating layer 430. According to an embodiment, the second area S2 may include a bent portion S21 adjacent to the first area S1 and an extension S22 extending from the bent portion S21. For example, the bent portion S21 may have a shape bent or inclined toward the second coating layer 430. At least a portion of the bent portion S21 may form a curved surface bent in the -Z-axis direction.

According to an embodiment, the first area S1 and the second area S2 of the glass 410 may have different heights from a lower surface (e.g., a side facing the -Z axis) of the cover structure 400. For example, a height of the first area S1 from the lower surface (e.g., a side facing the -Z axis) of the cover structure 400 may be greater than a height of the second area S2. As the bent portion S21 of the second area S2 seamlessly extends from the first area S1 to the extension S22 of the second area S2, a height of the bent portion S21 of the second area S2 may gradually (or sequentially) decrease.

According to an embodiment, the first area S1 of the glass 410 may be positioned at one end (e.g., -Y-axis direction) and the other end (e.g., +Y-axis direction) of the second area S2. The first area S1 may include a 1-1th area S11 and a 1-2th area S12 spaced apart from each other with the second area S2 therebetween. The 1-1th area S11 may have a relatively longer length compared to the 1-2th area S12. In a slidable electronic device, the 1-1th area S11 may be an area that is always visible during slide-in to slide-out operation and forms a plane, and the 1-2th area S12 may be an area that is always positioned inside the electronic device during slide-in to slide-out operation and is not visible, and always forms a plane. Referring to FIG. 32, the glass 410 may be formed without a pattern as a whole, and a thickness of the second area S2 of the glass 410 may be substantially the same as a thickness of the first area S1. A thickness of the glass 410 may be about 30 µm to 70 µm as a whole.

Referring to FIG. 33, the second area S2 of the glass 610 may form a pattern. The designated pattern may be at least one of a plurality of openings penetrating from a front surface to a rear surface of the glass 610, a plurality of recesses formed on a front surface and/or a rear surface of the glass 610, or a plurality of protruding portions. A thickness of the glass 610 may be about 70 µm or more (e.g., 70 µm to 400 µm) as a whole.

According to an embodiment, the first coating layer 620 may be disposed on the glass 610. Referring to FIG. 32, the first coating layer 620 may include a first portion 621 disposed on the first area S1 of the glass 610 and a second portion 622 disposed on the second area S2 of the glass 610. Referring to FIG. 33, the first coating layer 620 may include a first portion 621 disposed on the first area S1 of the glass 610.

According to an embodiment, the first coating layer 620 (or a portion of the second portion 622 of the first coating layer 620) may have a bent (e.g., inclined) shape corresponding to the bent portion S21 of the glass 610. For example, a rear surface of the first coating layer 620 (or a rear surface of the second portion 622 of the first coating layer 620) may be formed to be inclined with respect to a front surface of the glass 610 (or a rear surface of the first portion 621 of the first coating layer 620). According to an embodiment, the first coating layer 620 (or a front surface (e.g., a side facing the +Z axis) of the first portion 621 and the second portion 622 of the first coating layer 620) may form an overall flat surface.

Referring to FIG. 32, the second portion 622 of the first coating layer 620 may be positioned (e.g., filled) entirely along a front surface of the second area S2 of the glass 610.

Referring to FIG. 33, the first coating layer 620 may be disposed only on the second area S2 of the glass 610 and may be excluded from other areas.

According to an embodiment, the second coating layer 630 may be disposed below the glass 610. The second coating layer 630 may include a first portion 631 disposed on the first area S1 of the glass 610 and a second portion 632 disposed on the second area S2 of the glass 610.

According to an embodiment, at least a portion of the second portion 632 of the second coating layer 630 may have a bent (e.g., inclined) shape corresponding to the second area S2 of the glass 610. For example, a front surface (e.g., a side facing the +Z axis) of a portion of the second portion 632 may be formed to be inclined with respect to a front surface (e.g., a side facing the +Z axis) of the first portion 631. According to an embodiment, a rear surface (e.g., a side facing the -Z axis) of the first portion 631 and the second portion 632 of the second coating layer 630 may form an overall flat surface.

Referring to FIG. 32, the second portion 632 of the second coating layer 630 may be positioned (e.g., filled) entirely along a rear surface of the second area S2 of the glass 610.

Referring to FIG. 33, the second portion 622 of the second coating layer 630 may be positioned (e.g., filled) along a bent surface and a flat surface of the second area S2 of the glass 610, and at least a portion thereof may provide a form filling a space of a shape of the pattern of the second area S2 (e.g., the plurality of openings P1).

FIGS. 32 and 33 illustrate a bent shape (e.g., an inclined shape) of the glass 610 and surrounding areas thereof, and the disclosure is not limited thereto and may be easily modified for a display cover structure favorable for bending considering a thickness change of the glass 610 and diversification of patterns.

According to an embodiment of FIGS. 31 to 33, a cover structure 600, 600a favorable for a display that is bent or rolled according to a slide-in or slide-out state change may be provided in a slidable electronic device. The cover structure 600, 600a (e.g., the glass 610) may easily and stably receive a variable amount of the glass that flexibly extends during bending, thereby obtaining effects of resolving repulsive force and enhancing wrinkles (crease).

FIG. 34 is a view illustrating a front surface of a flexible cover structure 700, 700a in an unfolded state of a multi-foldable electronic device according to an embodiment of the disclosure.

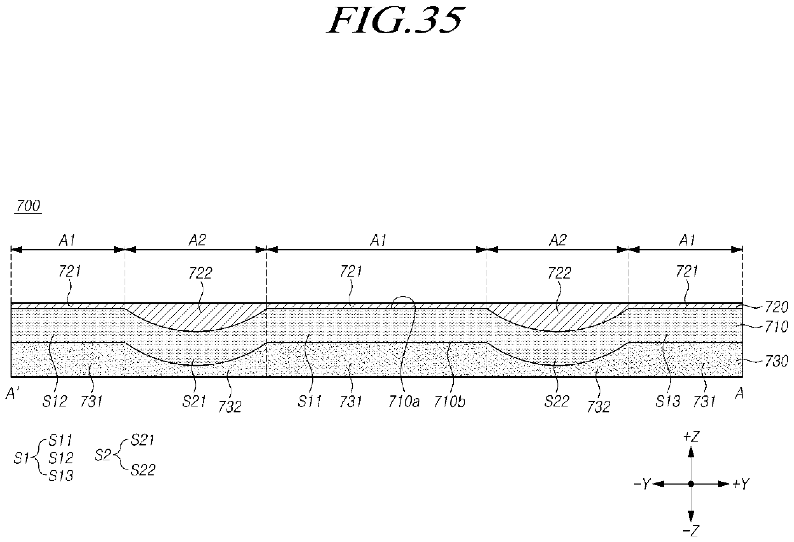

FIG. 35 is a cross-sectional view illustrating the flexible cover structure 700 taken along line A-A' of FIG. 34 according to an embodiment of the disclosure.

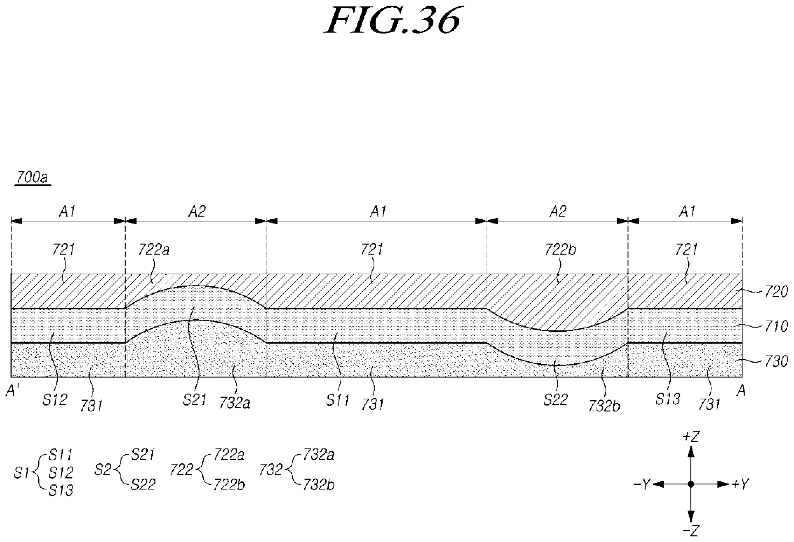

FIG. 36 is a cross-sectional view illustrating the flexible cover structure 700a taken along line A-A' of FIG. 34 according to an embodiment of the disclosure.

According to an embodiment, a multi-foldable electronic device (e.g., the electronic device 101 of FIG. 1) may include a first housing, a second housing, a third housing, and a flexible display. For example, the multi-foldable electronic device may be an electronic device that may be folded two or more times. The flexible display may include a flexible display panel and a flexible cover structure 700, 700a formed such that at least a portion thereof is exposed to the outside to protect the flexible display panel.

According to an embodiment, according to a state of the multi-foldable electronic device (e.g., from an unfolded state to a folded state), the flexible display may vary to an unfolded state, an intermediate state, and a folded state. In an unfolded state of the multi-foldable electronic device, the second housing and the third housing may be disposed in parallel on two opposite sides of the first housing.

According to an embodiment, in a folded state of the multi-foldable electronic device, the first, second, and third housings may be disposed to overlap each other. For example, the third housing may be disposed on an upper side of the first housing, and then the second housing may be disposed on an upper side of the third housing. For example, the third housing may be disposed between the first housing and the second housing. (e.g., G-type multi-folding, see FIG. 35)

According to an embodiment, in a folded state of the multi-foldable electronic device, the first, second, and third housings may be disposed to overlap each other. For example, the second housing may be disposed on an upper side of the first housing, and the third housing may be disposed on a lower side of the first housing. For example, the first housing may be disposed between the second housing and the third housing. (e.g., Z-type, S-type multi-folding, see FIG. 36)

According to an embodiment, the flexible cover structure 700, 700a may be a flexible structure to correspond to operations of the unfolded state, the intermediate state, and the folded state of the flexible display.

The configuration of the flexible cover structure 700, 700a of FIGS. 34 to 36 may be identical in portion or in whole to the configuration of the display 230 of FIGS. 2A and 4 and/or the configuration of the flexible cover structure 400, 400a, 400c, 400d, 400e, 400f, 400g, 400h, 500, 500a of FIGS. 5 to 30. The embodiment of FIGS. 34 to 36 may be partially combined with the embodiments of FIGS. 4 to 33.

According to an embodiment, the flexible cover structure 700, 700a may include a glass 710, a first coating layer 720 disposed on the glass 710, and a second coating layer 730 disposed below the glass 710.

According to an embodiment, the glass 710 may include a first area S1 and a second area S2 extending from the first area S1 and corresponding to a bending or rolling area of the flexible display panel. The first area S1 and the second area S2 may form an overall uniform thickness (e.g., the same thickness).

According to an embodiment, the second area S2 may include a spaced apart 2-1th area S21 and a 2-2th area S22. The first area S1 may include a 1-1th area S11, a 1-2th area S12, and a 1-3th area S13. For example, the first area S1 may include a 1-1th area S11 and a 1-2th area S12 spaced apart from each other with the 2-1th area S21 therebetween. The first area S1 may include a 1-1th area S11 and a 1-3th area S13 spaced apart from each other with the 2-2th area S22 therebetween.

Referring to FIG. 35 according to an embodiment, the second area S2 of the glass 710 may have a shape bent in a direction toward the second coating layer 730. According to an embodiment, the second area S2 of the glass 710 may have a shape bent in a direction toward the display panel. For example, a front surface 710a of the second area S2 may be formed to be concave with respect to a front surface 710a of the first area S1 (e.g., the 1-1th area S11, the 1-2th area S12, and the 1-3th area S13), and a rear surface 710b of the second area S2 may be formed to be convex with respect to a rear surface 710b of the first area S1 (e.g., the 1-1th area S11, the 1-2th area S12, and the 1-3th area S13). For example, the front surface 710a of the second area S2 may form a curved surface bent in the -Z-axis direction compared to the front surface 710a of the first area S1 (e.g., the 1-1th area S11, the 1-2th area S12, and the 1-3th area S13), and the rear surface 710b of the second area S2 may form a curved surface bent in the -Z-axis direction compared to the rear surface 710b of the first area S1 (e.g., the 1-1th area S11, the 1-2th area S12, and the 1-3th area S13).

Referring to FIG. 36 according to an embodiment, the second area S2 of the glass 710 may have a shape bent in a direction toward the second coating layer 730 and a direction toward the first coating layer 720. According to an embodiment, a portion of the second area S2 of the glass 710 may have a shape bent in a direction toward the display panel, and another portion of the second area S2 may have a shape bent in a direction opposite to the display panel. For example, a front surface 710a of the 2-1th area S21 may be formed to be convex with respect to a front surface 710a of the first area S1 (e.g., the 1-1th area S11 and the 1-2th area S12), and a rear surface 710b of the 2-1th area S21 may be formed to be concave with respect to a rear surface 710b of the first area S1 (e.g., the 1-1th area S11 and the 1-2th area S12). For example, a front surface 710a of the 2-2th area S22 may be formed to be concave with respect to a front surface 710a of the first area S1 (e.g., the 1-1th area S11 and the 1-3th area S13), and a rear surface 710b of the 2-2th area S22 may be formed to be convex with respect to a rear surface 710b of the first area S1 (e.g., the 1-1th area S11 and the 1-3th area S13). For example, the front surface 710a of the 2-1th area S21 may form a curved surface bent in the +Z-axis direction compared to the front surface 710a of the first area S1 (e.g., the 1-1th area S11 and the 1-2th area S12), and the rear surface 710b of the 2-1th area S21 may form a curved surface bent in the +Z-axis direction compared to the rear surface 710b of the first area S1 (e.g., the 1-1th area S11 and the 1-2th area S12). For example, the front surface 710a of the 2-2th area S22 may form a curved surface bent in the -Z-axis direction compared to the front surface 710a of the first area S1 (e.g., the 1-1th area S11 and the 1-3th area S13), and the rear surface 710b of the 2-2th area S22 may form a curved surface bent in the -Z-axis direction compared to the rear surface 710b of the first area S1 (e.g., the 1-1th area S11 and the 1-3th area S13).

According to an embodiment, referring to the cross-sections of FIGS. 35 and 36, the 2-1th area S21 and the 2-2th area S22 of the glass 710 may each have a symmetrical shape with respect to a folding axis (e.g., line C-C' and line C"-C‴ of FIG. 34). A value (e.g., an absolute value) of a slope (e.g., a slope of a tangent line) of the front surface 710a and/or the rear surface 710b of the second area S2 of the glass 710 may gradually (or sequentially) increase away from the folding axis (e.g., line C-C' and line C"-C‴ of FIG. 34).

According to an embodiment, the first coating layer 720 may be disposed on the glass 710 (e.g., on the front surface 710a). The first coating layer 720 may include a first portion 721 disposed on the first area S1 of the glass 710 and a second portion 722 disposed on the second area S2 of the glass 710. The second portion 722 of the first coating layer 720 may correspond to a bending or rolling area of the flexible display (e.g., the second area S2 of the glass 710).

According to an embodiment, the second coating layer 730 may be a structure whose shape varies along a long length direction (e.g., Y-axis direction). The first portion 721 and the second portion 722 of the second coating layer 730 may have different shapes. For example, a thickness of the first portion 721 and a thickness of the second portion 722 may be different.

Referring to FIG. 35 according to an embodiment, at least a portion of the second portion 722 of the first coating layer 720 may have a shape bent in a direction toward the glass 710. For example, a rear surface (e.g., a side facing the -Z axis) of the second portion 722 may be formed to be convex with respect to a rear surface (e.g., a side facing the -Z axis) of the first portion 721. A front surface (e.g., a side facing the +Z axis) of the second portion 722 may extend to form a flat surface with a front surface (e.g., a side facing the +Z axis) of the first portion 721.

Referring to FIG. 36 according to an embodiment, at least a portion of the second portion 722 of the first coating layer 720 may have a shape bent in a direction toward the glass 710 and in an opposite direction. For example, a rear surface (e.g., a side facing the -Z axis) of the 2-1th portion 722a may be formed to be concave with respect to a rear surface (e.g., a side facing the +Z axis) of the first portion 721. A rear surface (e.g., a side facing the -Z axis) of the 2-2th portion 722b may be formed to be convex with respect to a rear surface (e.g., a side facing the +Z axis) of the first portion 721. A front surface (e.g., a side facing the +Z axis) of the second portion 722 may extend to form a flat surface with a front surface (e.g., a side facing the +Z axis) of the first portion 721.

According to an embodiment, the second coating layer 730 may be disposed below the glass 710 (e.g., on the rear surface 710b). The second coating layer 730 may include a first portion 731 disposed below the first area S1 of the glass 710 and a second portion 732 disposed below the second area S2 of the glass 710. The second portion 732 of the second coating layer 730 may correspond to a bending or rolling area of the flexible display (e.g., the second portion S2 of the glass 710).

According to an embodiment, the second coating layer 730 may be a structure whose shape varies along a long length direction (e.g., Y-axis direction). The first portion 731 and the second portion 732 of the second coating layer 730 may have different shapes. For example, a thickness of the first portion 731 and a thickness of the second portion 732 may be different.

Referring to FIG. 35 according to an embodiment, at least a portion of the second portion 732 of the second coating layer 730 may have a shape bent in a direction opposite to the glass 710 (e.g., -Z-axis direction). For example, a front surface (e.g., a side facing the +Z axis) of the second portion 732 may be formed to be concave with respect to a front surface (e.g., a side facing the +Z axis) of the first portion 731. For example, the front surface of the second portion 732 may form a curved surface bent in the -Z-axis direction compared to the front surface of the first portion 731. A rear surface (e.g., a side facing the -Z axis) of the second portion 732 may extend to form a flat surface with a rear surface (e.g., a side facing the -Z axis) of the first portion 731.

Referring to FIG. 36 according to an embodiment, at least a portion of the second portion 732 of the second coating layer 730 may have a shape bent in a direction toward the glass 710 and in an opposite direction (e.g., -Z-axis direction). For example, a front surface (e.g., a side facing the +Z axis) of the 2-1th portion 732a may be formed to be convex with respect to a front surface (e.g., a side facing the +Z axis) of the first portion 731. A front surface (e.g., a side facing the +Z axis) of the 2-2th portion 732b may be formed to be concave with respect to a front surface (e.g., a side facing the +Z axis) of the first portion 731. For example, a portion of the front surface of the second portion 732 may form a curved surface bent in the -Z-axis direction compared to the front surface of the first portion 731, and another portion of the front surface may form a curved surface bent in the +Z-axis direction compared to the front surface of the first portion 731. A rear surface (e.g., a side facing the -Z axis) of the second portion 732 may extend to form a flat surface with a rear surface (e.g., a side facing the -Z axis) of the first portion 731.

According to an embodiment of FIGS. 34 to 36, in a multi-foldable electronic device, a cover structure 700; 700a favorable for a display that is bent or rolled according to a change among a folded state, an intermediate state, and an unfolded state may be provided. The cover structure 700; 700a (e.g., the glass 710) may easily and stably receive a variable amount of the glass that flexibly extends during bending, thereby obtaining effects of resolving repulsive force and enhancing wrinkles (crease). In an electronic device including a flexible display according to an embodiment of the disclosure, a cover structure that protects the flexible display and facilitates bending may be provided.

According to an embodiment of the disclosure, a cover structure protecting a flexible display includes a glass, and the glass may provide a bent shape and/or a pattern (e.g., an opening, a recess) in a bending section to be advantageous for bending. Accordingly, a repulsive force of a folding section may be enhanced.

According to an embodiment of the disclosure, a cover structure protecting a flexible display includes a glass and coating layers disposed on two opposite surfaces of the glass, and by filling a coating layer in a curved surface and/or a pattern of the glass, impact resistance performance of a folding section may be enhanced.

According to an embodiment of the disclosure, a cover structure protecting a flexible display may remove one polymer film that is generally a cause of an increase in stacked thickness, and may enhance (e.g., reduce or limit) display wrinkles (crease) due to permanent deformation of the polymer film and enhance (e.g., increase) a user experience (e.g., a touch feeling).

The effects obtainable in the disclosure are not limited to the effects mentioned above, and other effects not mentioned may be clearly understood by those of ordinary skill in the art to which the disclosure belongs from the description below.

An electronic device (e.g., 101 of FIGS. 1 to 4) according to an embodiment of the disclosure may include a first housing (e.g., 210 of FIGS. 2A to 4), a second housing (e.g., 220 of FIGS. 2A to 4), a flexible display panel (e.g., 235 of FIG. 4) including an area corresponding to the first housing and an area corresponding to the second housing, and a flexible cover structure (e.g., 400 of FIG. 6) disposed on the flexible display panel. The flexible cover structure may include a glass (e.g., 410 of FIG. 6) including a first area (e.g., S1 of FIG. 6) and a second area (e.g., S2 of FIG. 6) extending from the first area and corresponding to a bending or rolling area of the flexible display panel, a first coating layer (e.g., 420 of FIG. 6) disposed over at least a portion of a front surface (e.g., 410a of FIG. 6) of the glass, and a second coating layer (e.g., 430 of FIG. 6) disposed on a rear surface (e.g., 410b of FIG. 6) of the glass. At least a portion of the second area of the glass may have a shape bent in a direction toward the second coating layer.

According to an embodiment, the second area of the glass may protrude in a direction of the second coating layer with respect to the first area.

According to an embodiment, the second area of the glass may be convex in a direction of the second coating layer with respect to the first area.

According to an embodiment, a thickness of the glass may be 30 µm to 200 µm.

According to an embodiment, the first area and the second area of the glass may have substantially the same thickness.

According to an embodiment, a thickness of the second area of the glass may be smaller than a thickness of the first area.

According to an embodiment, a thickness of the second area of the glass may gradually decrease away from an area adjacent to the first area.

According to an embodiment, a sum of thicknesses of the first coating layer, the glass layer, and the second coating layer forming a bending section (e.g., A2 of FIG. 6) of the cover structure may be substantially equal to a sum of thicknesses of the first coating layer, the glass layer, and the second coating layer forming a flat section (e.g., A1 of FIG. 6) of the cover structure.

According to an embodiment, the first coating layer may not be disposed on the first area of the glass.

According to an embodiment, the second area of the glass may include a plurality of openings (e.g., P1 of FIG. 6) penetrating from the front surface (e.g., a side facing the +Z axis) to the rear surface (e.g., a side facing the -Z axis).

According to an embodiment, the cover structure may further include a third coating layer (e.g., 440 of FIG. 20) filling the plurality of openings (e.g., P1 of FIG. 6) of the second area of the glass.

According to an embodiment, the second area of the glass may include a plurality of recesses (e.g., P2 of FIG. 6) formed on at least one of the front surface (e.g., a side facing the +Z axis) or the rear surface (e.g., a side facing the -Z axis).

According to an embodiment, the cover structure may further include a third coating layer (e.g., 440 of FIG. 19) filling the plurality of recesses (e.g., P2 of FIG. 6) of the second area of the glass.

According to an embodiment, the cover structure may further include a protective layer (e.g., 480 of FIG. 13) disposed on the first coating layer.

According to an embodiment, the electronic device may further include a moving module rotatably connected to the first housing and the second housing. A width (e.g., A2 of FIG. 4) of the second area of the glass may be smaller than a width (e.g., B of FIG. 4) of the moving module.

According to an embodiment, the flexible display panel may be disposed adjacent to the second coating layer rather than the first coating layer.

According to an embodiment, the flexible display panel may be disposed adjacent to the first coating layer rather than the second coating layer.

A flexible cover structure (e.g., 400 of FIG. 6) according to an embodiment of the disclosure may include a glass (e.g., 410 of FIG. 6) including a first area (e.g., S1 of FIG. 6) and a second area (e.g., S2 of FIG. 6) extending from the first area and corresponding to a bending or rolling area of the flexible display panel, a first coating layer (e.g., 420 of FIG. 6) disposed over at least a portion of a front surface (e.g., 410a of FIG. 6) of the glass, and a second coating layer (e.g., 430 of FIG. 6) disposed on a rear surface (e.g., 410b of FIG. 6) of the glass. At least a portion of the second area of the glass may have a shape bent in a direction toward the second coating layer.

According to an embodiment, the second area of the glass may protrude in a direction of the second coating layer with respect to the first area.

According to an embodiment, the first area and the second area of the glass may have substantially the same thickness.

According to an embodiment, a thickness of the second area of the glass may be smaller than a thickness of the first area.

According to an embodiment, the first area of the thin glass may include a 1-1th area (e.g., S11 of FIGS. 35 and 36), a 1-2th area (e.g., S12 of FIGS. 35 and 36), and a 1-3th area (e.g., S13 of FIGS. 35 and 36) spaced apart from each other. The second area of the thin glass may include a 2-1th area (e.g., S21 of FIGS. 35 and 36) disposed between the 1-1th area (e.g., S11 of FIGS. 35 and 36) and the 1-2th area (e.g., S12 of FIGS. 35 and 36), and a 2-2th area (e.g., S22 of FIGS. 35 and 36) disposed between the 1-1th area (e.g., S11 of FIGS. 35 and 36) and the 1-3th area (e.g., S13 of FIGS. 35 and 36).

It should be appreciated that various embodiments of the disclosure and the terms used therein are not intended to limit the technological features set forth herein to particular embodiments and include various changes, equivalents, or replacements for a corresponding embodiment.

## Claims

1. An electronic device (101) comprising:
a first housing (210);
a second housing (220);
a flexible display panel (235) including an area corresponding to the first housing and an area corresponding to the second housing; and
a flexible cover structure (400) disposed on the flexible display panel,
the flexible cover structure comprising:
a glass (410) including a first area (S1) and a second area (S2) extending from the first area and corresponding to a bending or rolling area of the flexible display panel;
a first coating layer (420) disposed over at least a portion of a front surface (410a) of the glass; and
a second coating layer (430) disposed on a rear surface (410b) of the glass,
wherein at least a portion of the second area of the glass has a shape bent in a direction toward the second coating layer.

2. The electronic device of claim 1,
wherein the second area of the glass protrudes in a direction of the second coating layer with respect to the first area.

3. The electronic device of claim 1 or 2,
wherein a thickness of the glass is 30*µ*m to 200*µ*m.

4. The electronic device of any one of claims 1 to 3,
wherein the first area and the second area of the glass have substantially the same thickness.

5. The electronic device of any one of claims 1 to 3,
wherein a thickness of the second area of the glass is smaller than a thickness of the first area.

6. The electronic device of claim 5,
wherein a thickness of the second area of the glass gradually decreases away from an area adjacent to the first area.

7. The electronic device of any one of claims 1 to 6,
wherein a sum of thicknesses of the first coating layer, the glass and the second coating layer forming a bending section (A2) of the cover structure is substantially equal to a sum of thicknesses of the first coating layer, the glass, and the second coating layer forming a flat section (A1) of the cover structure.

8. The electronic device of any one of claims 1 to 7,
wherein the first coating layer is not disposed on the first area of the glass.

9. The electronic device of any one of claims 1 to 8,
wherein the second area of the glass includes a plurality of openings (P1) penetrating from the front surface (e.g., a side facing the +Z axis) to the rear surface (e.g., a side facing the -Z axis).

10. The electronic device of claim 9,
wherein the cover structure further includes a third coating layer (440) filling the plurality of openings (P1) of the second area of the glass.

11. The electronic device of any one of claims 1 to 8,
wherein the second area of the glass includes a plurality of recesses (P2) formed on at least one of the front surface (e.g., a side facing the +Z axis) or the rear surface (e.g., a side facing the - Z axis).

12. The electronic device of claim 11,
wherein the cover structure further includes a third coating layer (440) filling the plurality of recesses (P2) of the second area of the glass.

13. The electronic device of any one of claims 1 to 12,
wherein the cover structure further includes a protective layer (480) disposed on the first coating layer.

14. The electronic device of any one of claims 1 to 13, further comprising,
a moving module rotatably connected to the first housing and the second housing, and
wherein a width (A2) of the second area of the glass is smaller than a width (B) of the moving module.

15. The electronic device of any one of claims 1 to 14,
wherein the flexible display panel is disposed closer to the second coating layer than to the first coating layer.
